# FASCICULE DE BREVET EUROPEEN

(11) **EP 0 931 103 B1**
(45) Date de publication et mention de la délivrance du brevet: **09.06.2004**
(21) Numéro de dépôt: 97951126.8
(22) Date de dépôt: 27.09.1997
(51) Int. Cl.: C08G 59/02, C08G 59/24, C08G 59/32, C09D 163/00

(54) **MONOMERES, OLIGOMERES ET POLYMERES A GROUPES OXIRANNES TERMINAUX, LEUR PROCEDE DE PREPARATION ET LEUR POLYMERISATION CATIONIQUE SOUS IRRADIATION**
MONOMERE, OLIGOMERE UND POLYMERE MIT OXIRANENDGRUPPEN, VERFAHREN ZU IHRER HERSTELLUNG UND IHRE KATIONISCHE STRAHLUNGSPOLYMERISATION
MONOMERS, OLIGOMERS AND POLYMERS WITH TERMINAL OXIRANE GROUPS, METHOD OF PREPARATION AND POLYMERISATION UNDER RADIATION EXPOSURE

(30) Priorité: 30.09.1996 BE 9600821
(43) Date de publication de la demande: 28.07.1999
(73) Titulaire: UCB, S.A., 1070 Bruxelles (BE)
(72) Inventeur: PEETERS, Stephan, B-3001 Heverlee (BE); VERSCHUEREN, Kris, B-1702 Groot-Bijgaarden (BE); LOUTZ, Jean-Marie, B-1180 Bruxelles (BE)
(74) Mandataire: Lechien, Monique
(86) Numéro de dépôt international: PCT/EP1997/005303
(87) Numéro de publication internationale: WO 1998/014497

(56) Documents cités:
- EP-A- 0 139 042
- EP-A- 0 221 559
- EP-A- 0 262 414
- EP-A- 0 467 258

## Description

La présente invention se rapporte à de nouveaux monomères, oligomères et polymères porteurs de fonctions époxy cycloaliphatiques, capables d'être polymérisés sous irradiation, ainsi qu'à des revêtements présentant, par comparaison avec les systèmes polymérisables cationiquement connus jusqu'à présent, une résistance améliorée aux solvants, obtenus par polymérisation cationique de compositions contenant lesdits monomères, oligomères et polymères porteurs de fonctions époxy cycloaliphatiques.

L'industrie des revêtements est en permanence à la recherche de matériaux présentant une meilleure résistance aux agressions chimiques et, en particulier, aux solvants, détergents, nettoyants, décapants et autres substances capables d'attaquer les surfaces et d'en modifier les qualités essentielles de couleur, de durabilité. de porosité, etc. Par ailleurs cette même industrie est aussi à la recherche de matériaux qui, tout en possédant la résistance améliorée exprimée ci-dessus, soient polymérisables sous forme de revêtement, en couche mince ou épaisse, en ayant recours soit au durcissement thermique soit à l'une des techniques d'irradiation telles que le rayonnement ultraviolet ou bien les radiations ionisantes telles que rayons gamma, rayon X ou faisceau d'électrons. Ces techniques ont en effet acquis dans l'industrie une réputation bien établie de fiabilité et de productivité grâce aux vitesses élevée de polymérisation qu elles permettent d'atteindre et à la régularité des caractéristiques de revétements ainsi obtenus.

Des revétements ont déjà été obtenus par polymérisation de compositions contenant des oligomères et polymères, notamment polyesters et polyethers porteurs de fonctions époxy cycloaliphatiques. Ainsi le brevet US-A-3.968.135 décrit la promotion catalytique de la réaction de composés contenant des groupes oxiranes avec des composés carboxyliques organiques au moyen d'un composé tricarboxylate de chrome III possédant des sites de coordination disponibles, en présence d'un système solvant comprenant un solvant neutre et un solvant de coordination. Ce procédé est appliqué à la réaction soit d'un composé monoépoxy avec un acide di- ou polycarboxylique soit d'un diépoxyde avec un monoacide. En particulier ce document décrit que l'époxyde peut être le dicyclohexène carboxylate époxydé et que l'acide polyfonctionnel peut être un polyester ou polyéther à terminaison carboxy. Cependant le rapport molaire entre les composés à faire réagir est tel que toutes les fonctions acides disponibles, conduisent à la réticulation immédiate et complète du matériau obtenu. Ainsi les exemples de ce document décrivant plus spécifiquement des systèmes triépoxyde/diacide et triacide/diépoxyde capables de réticuler à 75°C en 15 minutes seulement. Ces systèmes peuvent être utilisés, sous forme de solutions ou d'émulsions, comme compositions de revêtement. Aucune mention d'un photoinitiateur cationique n'est présente dans ce document.

Toutefois pour un certain nombre de créneaux d'application, ces polymères n'offrent pas l'ensemble du compromis de propriétés désirées. Pour ces applications, on souhaiterait d'autre part disposer de compositions à base de polyacrylates, de polyuréthanes ou de l'un ou l'autre des monomères entrant dans la constitution de ces polymères. Pour l'ensemble de ces compositions partant de différents polymères de base, on souhaiterait enfin un aptitude satisfaisante à polymériser sous irradiation, notamment par l'effet de rayonnement ultraviolet ou de radiations ionisantes dans les conditions industrielles courantes.

Pour résoudre les problèmes exposés ci-dessus, la présente invention propose une nouvelle catégorie de monomères, oligomères et polymères choisis parmi ceux de formule générale(I): 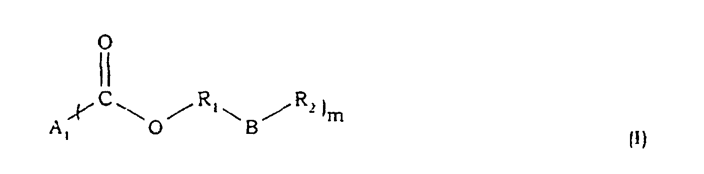 dans laquelle:
- A₁ est choisi parmi les séquences polyesters ayant un poids moléculaire compris entre 250 et 10000 environ, les séquences polyuréthannes ayant un poids moléculaire compris entre 500 et 5000 environ, les squelettes hydrocarbonés d'un acide mono- ou polycarboxylique, et les produits d'addition d'un acide polycarboxylique et d un diépoxyde cycloaliphatique, lesdits produits d'addition étant de préférence obtenus par réaction de x moles de diépoxyde cycloaliphatique avec x + 2 moles de diacide carboxylique.
- m est un nombre de 1 à 6.
- R₁ est un groupe cycloaliphatique porteur d'un groupe hydroxyle situé en β de l'atome d oxygène auquel est lié R₁ et le cas échéant porteur de substituant(s),
- R₂ est un second groupe cycloaliphatique porteur d'un groupe oxiranne situé en extrémité de chaine et le cas échéant porteur de substituant(s), et
- B est choisi parmi une ou plusieurs liaisons covalentes, un atome d'oxygène et des radicaux hydrocarbonés linéaires, ramifiés ou cycliques porteurs le cas échéant d'atomes d oxygène et/ ou de silicium,
   et ceux de formule générale (II): 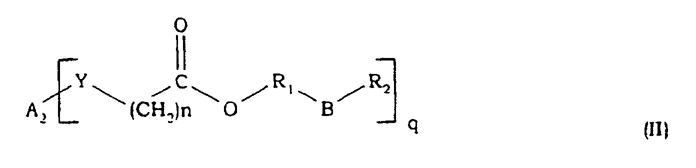 dans laquelle:
   - A₂ est une séquence choisie parmi les homopolymères et copolymères d'au moins un monomère vinylique,
- n est un nombre entier de 0 à 15 environ, avec la condition que n est au moins égal à 1 lorsque Y est le soufre, et
- Y est choisi parmi l'atome de soufre, les radicaux -CR'R" dans lesquels R' et R" sont chacun un groupe aliphatique ayant de 1 à 4 atomes de carbone, et leur mélanges,
- q est un nombre, entier ou non, allant de 1 à 2,
- R₁, B et R₂ sont définis comme dans la formule (I) ci-dessus.

Pour la bonne compréhension de l'invention, chacun des termes R₁, R₂, A₁, A₂ et B sera maintenant défini de manière plus détaillée.

R₁ et R₂ sont des groupes cycloaliphatiques dont le cycle possède de préférence 5 à 6 chaînons, pouvant porter un ou plusieurs substituants de préférence hydrocarbonés et de préférence peu encombrés stériquement. Des exemples de tels substituants comprennent des radicaux alkyles ayant de 1 à 9 atomes de carbone tels que méthyle, éthyle, n-propyle. n-butyle, n-hexyle, 2-éthylhexyle, n-octyle et n-nonyle. Ces groupes cycloaliphatiques R₁ et R₂ portent en outre obligatoirement l'un (R₁) un groupe hydroxyle en position β par rapport à l'atome d'oxygène auquel R1 est lié, l'autre (R₂) un groupe oxiranne situé en extremité de la chaîne cyclique.

Les groupes cycloaliphatiques R₁ et R₂ sont reliés entre eux par un élément B qui peut être un atome d'oxygene ou bien une ou plusieurs, de préférence une ou deux, liaisons covalentes, par exemple comme dans les formules suivantes:

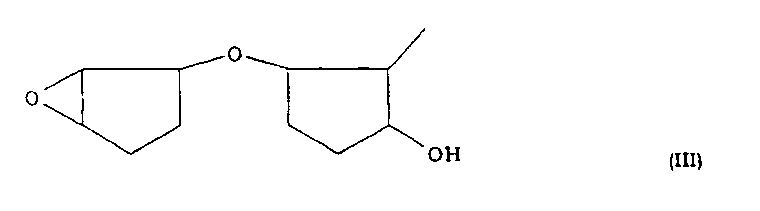

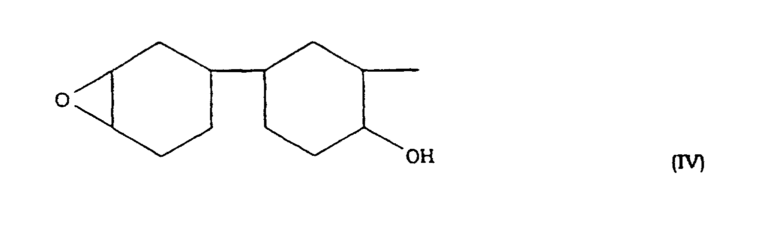

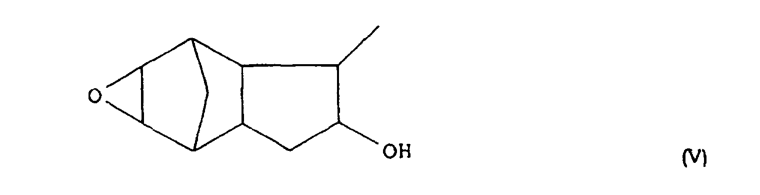

L'élément B peut également consister en un radical hydrocarboné linéaire. ramifié ou cyclique pouvant comprendre un ou plusieurs atomes d'oxygène et/ou de silicium dans la chaine carbonée. A titre d'exemples de tels radicaux B on peut citer:
- des groupes alkylènes -(CH₂)n- dans lesquels n est un nombre entier de 1 à 12 environ,
- un groupe -CH=CH-
- un groupe de formule 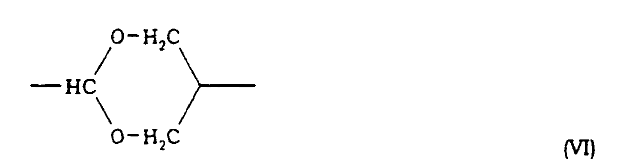 ou 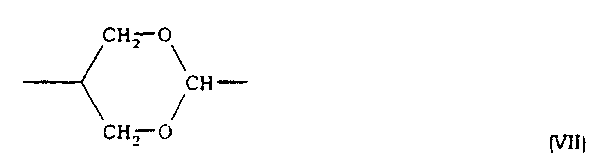
- un groupe de formule 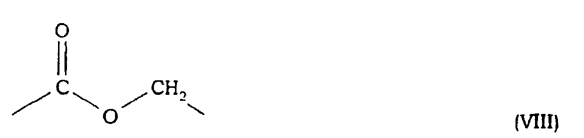 ou 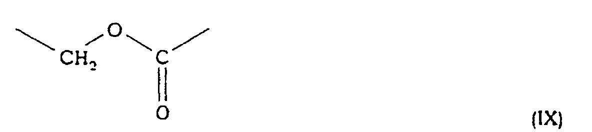
- un groupe de formule (X) 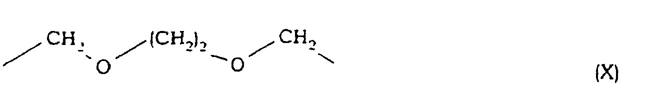
- un groupe de formule (XI) 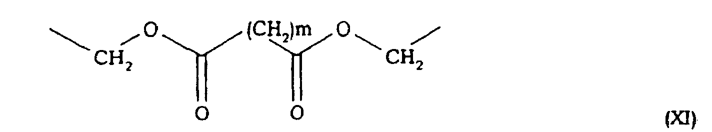 dans laquelle m est un nombre entier de 0 à 20 environ, de préférence de 1 à 6,
- un groupe de formule (XII) 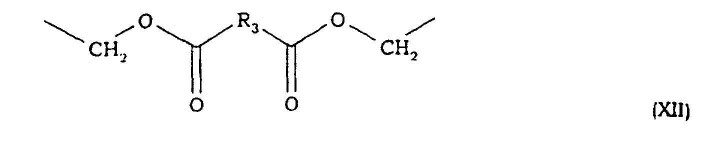 dans laquelle R₃ est un radical cycloaliphatique tel que 1,4-cyclohexane, 1,3-cyclohexane, 1,2-cyclohexane et similaires, ledit radical cyclique pouvant le cas échéant porter un groupe oxiranne
- un groupe de formule (XIII) 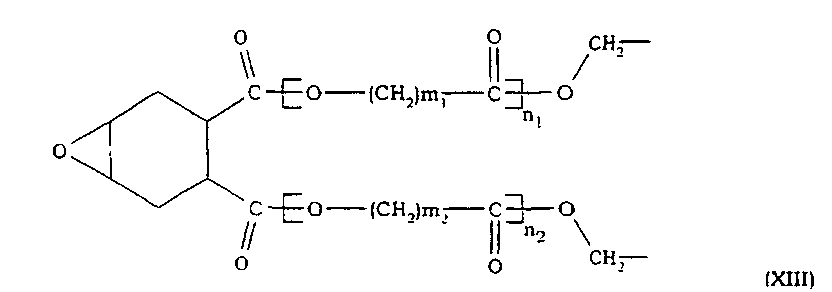 dans laquelle m₁ et m₂ sont chacun un nombre entier de 1 à 6 environ, et n₁ et n₂ sont chacun un nombre entier de 0 à 2
- un groupe de formule (XIV) 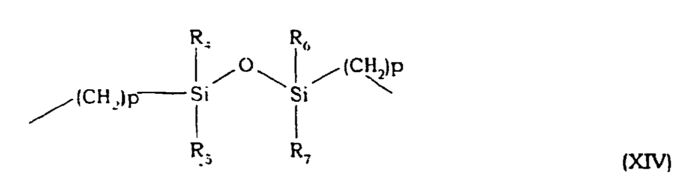 dans laquelle p est un nombre entier de 1 à 10 environ, de préférence de 1 à 3, R₄, R₅, R₆ et R₇ sont chacun choisis indépendamment parmi les radicaux alkyles ayant de 1 à 4 atomes de carbone, de préférence le radical méthyle,
- un groupe de formule (XV) 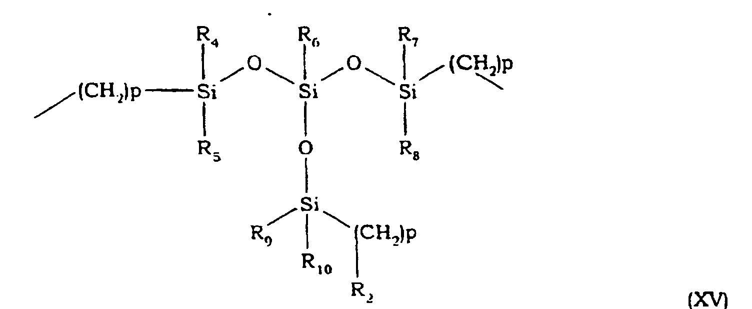 dans laquelle p est un nombre entier de 1 à 10 environ, de préférence 1 à 3, R₄, R₅, R₇, R₈, R₉ et R₁₀ et sont chacun choisis indépendamment, parmi les radicaux alkyles ayant de 1 à 4 atomes de carbone, de préférence le radical méthyle, et R₆ est choisi parmi les radicaux alkyles ayant de 1 à 4 atomes de carbone, de préférence le radical méthyle, et les radicaux aryles ayant de 6 à 9 atomes de carbone, de préférence le radical phényle, et R₂ a la même signification que dans la formule (I) ci-dessus,
- un groupe de formule (XVI) 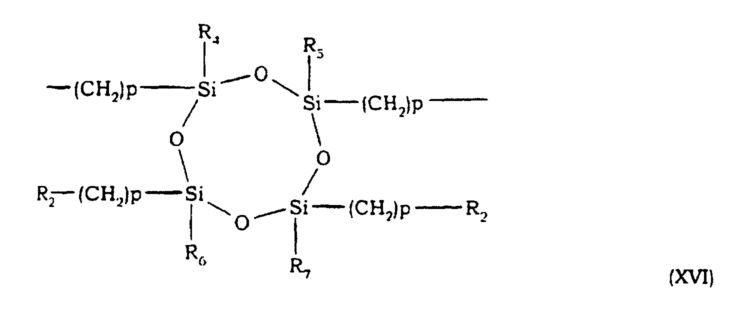 dans laquelle R₄, R₅, R₆ et R₇ sont chacun choisis indépendamment, parmi les radicaux alkyles ayant de 1 à 4 atomes de carbone, de préférence le radical méthyle, p est un nombre entier de 1 à 20 environ, de préférence 1 à 6, et R₂ a la méme signification que dans la formule (I) ci-dessus.

Comme indiqué précédemment. A₁ peut être le squelette hydrocarboné d un acide mono- ou polycarboxylique, de préférence choisi parmi les monoacides aliphatiques saturés comme l'acide laurique ou l'acide stéarique ou insaturés comme l'acide oléique, les diacides aliphatiques saturés ou insaturés ayant de 4 à 40 atomes de carbone environ tels que l'acide maléïque, l'acide fumarique, l'acide succinique, l'acide adipique, l'acide glutarique. l'acide azélaïque, l'acide décanedicarboxylique et l'acide 1,4-cyclohexanedicarboxylique et ies acides dimères, les diacides aromatiques tels que l'acide téréphtalique et l'acide isophtalique, les triacides carboxyliques tels que l'acide citrique et les acides trimères pouvant comporter jusqu à 60 atomes de carbone.

A₁ peut alternativement être une séquence polyester de poids moléculaire compris entre 250 et 10000 environ, de préférence entre 1000 et 5000, résultant de la polycondensation d'au moins un acide dicarboxylique aliphauque ou aromatique ou l'anhydride correspondant et d'au moins un polyol. Ce polyol peut être un glycol ou polyol tri-, tétra-, penta- ou hexahydroxylé tel que l'éthylène glycol, le diéthylène glycol, le propylène glycol, le 1,4-butanediol, le 1,6-hexanediol, le triméthylopropane, le ditriméthylopropane, le triméthyloléthane, le pentaérythritol, le dipentaérythritol et le 1,3,5-tris(2-hydroxyéthyl)-1,3,5-triazine-2,4,6(1H,3H,5H)-trione (ou tris(2-hydroxyéthyl)-isocyanurate. Il peut aussi s'agir d'un diol cycloaliphatique tel que le 2,2-[bis(4-hydroxycyclohexyl)]propane 1 ou bisphénol A hydrogéné), le 1,4-cyclohexanediméthanol, le 1,4-cyclohexanediol, le 2,2,4,4-tétraméthyl-1,3-cyclobutanediol, le 4,8-bis(hydroxyméthyl)tricyclo[5.2.1.02,6[décane (ou tricyclodècanediméthanol). Comme acide dicarboxylique (ou anhydride correspondant) utilisable dans la constitution de ce polyester on peut citer l'acide succinique, l'acide glutarique, l'acide adipique, l'acide pimélique, l'acide isophtalique, l'acide téréphtalique et l'acide 1,4,5,6,7,7-hexachloro-5-norbornène-2,3-dicarboxylique, l'anhydride succinique, l'anhydride maléïque ainsi que les anhydrides triméllitique et tétrachlorophtalique.

A₁ peut enfin être une séquence polyuréthanne de poids moléculaire compris entre 500 et 5000 environ, de préférence entre 1500 et 4000, résultant de la polycondensation d'au moins un polyisocyanate organique et d'au moins un acide polyhydroxylé. Comme exemple d'un tel acide on peut citer l'acide dihydroxyméthylpropionique. Pour cette polycondensation on peut en outre employer un polyol tel que celui retenu pour la constitution du polyester décrit ci-dessus.

Comme polyisocyanates organiques utilisables dans la constitution de ce polyuréthanne on peut citer des composés comprenant au moins deux fonctions isocyanates par molécule tels qu un polyisocyanate aliphatique, cycloaliphatique ou aromatique. Comme exemples de diisocyanates aliphatiques appropriés, on peut mentionner les 1,4-diisocyanatobutane, 1,6-diisocyanatohexane, 1,6-diisocyanato-2,2,4-triméthylhexane et 1,12-diisocyanatododécane, Les diisocyanates cycloaliphatiques particulièrement appropriés comprennent les 1.3- et 1,4-diisocyanatocyclohexane, 2,4-diisocyanato-1-méthylcyclohexane, 1,3-diisocyanato-2-méthylcyclohexane, 1-isocyanato-2-(isocyanatométhyl)cyclopentane, 1,1'-méthylènebis[4-isocyanatocyclohexane], 1,1'-(1-méthyléthylidène)bis[4-isocyanatocyclohexane], 5-isocyanato-1-isocyanatométhyl-1,3,3-triméthylcyclohexane (diisocyanate d'isophorone), 1,3- et 1,4-bis(isocyanatométhyl)cyclohexane, 1,1'-méthylènebis[4-isocyanato-3-méthylcyclohexane] et 1-isocyanato-4(ou 3)-isocyanatométhyl-1-méthylcyclohexane. Les diisocyanates aromatiques particulièrement appropriés comprennent les 1,4-diisocyanatobenzène, 1,1-méthylènebis[4-isocyanatobenzène], 2,4-diisocyanato-1-méthylbenzene, 1,3-diisocyanato-2-méthylbenzene, 1,5-diisocyanatonaphtalène, 1,1'-(1-méthyléthylidène)bis[4-isocyanatobenzène], 1,3- et 1,4-bis(1-isocyanato-1-méthyléthyl)benzène. Des polyisocyanates aromatiques ou aliphatiques contenant 3 groupes isocyanates ou plus peuvent aussi être utilisés, comme par exemple le 1,1',1"-méthylidynetris[4-isocyanatobenzène], le trimère de l'hexaméthylènediisocyanate et les polyisocyanates de polyphényl polyméthylène obtenus par phosgénation de condensats aniline/formaldéhyde. La quantité totale de polyisocyanate organique peut être de 10 à 60% en poids du polyuréthanne de la séquence A₁.

Comme indiqué précédemment, A₂ est une séquence polymère comprenant au moins des unités récurrentes provenant d'au moins un monomère vinylique, en particulier d'esters acryliques ou méthacryliques. Cette séquence peut être un homopolymère d'un tel ester ou bien un copolymère, le plus souvent statistique, de plusieurs tels esters, ou encore un copolymère d'au moins un ester (méth)acrylique et d'un (ou plusieurs) monomère(s) vinylaromatique(s) copolymérisable(s) avec ledit ester (méth)acrylique. Comme esters acryliques et méthacryliques pouvant entrer dans la composition de la séquence A₂ on peut citer les acrylates et méthacrylates ayant de 1 à 20 atomes de carbone environ dans le radical ester, tels que les acrylates de méthyle, d'éthyle, d'isopropyle, de n-propyle, d'isobutyle, de n-butyle, de ter-butyle, de 2-éthylhexyle et de n-octyle ainsi que les méthacrylates de n-pentyle, n-hexyle, de n-octyle, de n-dodécyle, de n-tétradécyle, d'isobornyle, de méthyle et d éthyle et des (méthlacrylates hydroxylés tels que ceux d'hydroxyéthyle ou d'hydroxypropyle. Comme autres monomères vinyliques pouvant entrer dans la composition de la séquence A₂ on peut citer principalement les (méth)acrylamides, des monomères vinylaromatiques tels que le styrène, le vinyltoluène, l'α-méthylstyrène et les styrènes substitués (notamment par un ou plusieurs atomes d'halogène) similaires, et d'autre part l'acétate de vinyle.

Selon un autre aspect, la présente invention concerne aussi un procédé de préparation des monomères, oligomères et polymères de formules (I) et (II), comprenant la réaction d un composé monomère ou polymère de formule générale (XVII) 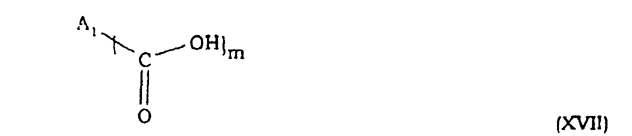 dans laquelle A₁ et m sont comme définis dans la formule (I) (en vue de l'obtention des composés de formule I) ou bien de formule générale (XVIII) 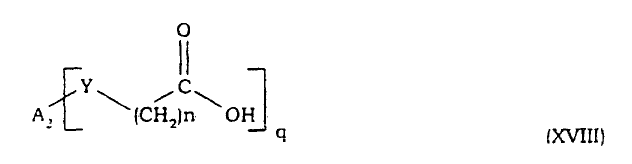 dans laquelle A₂, Y, q et n sont comme définis dans la formula (II) (en vue de l'obtention des composés de formule II) avec un diépoxyde cycloaliphatique de formule générale (XIX) 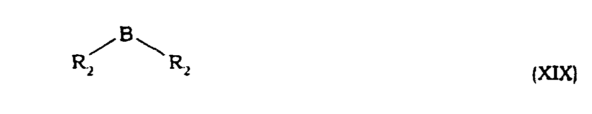 dans laquelle B et R₂ sont comme définis dans les formules (I) et (II), le rapport molaire du diépoxyde (XIX) au monomère ou polymère de formule (XVII) ou (XVIII) étant tel qu'au moins une fonction époxyde du composé (XIX) reste disponible pour une autre réaction ultérieure éventuelle.

Le trait distinctif du procédé selon l'invention réside dans le fait que, contrairement notamment à l'enseignement du brevet US-A-3.968.135, les conditions réactionnelles sont choisies de telle sorte que la réaction avec la (les) fonction(s) acide carboxylique presente(s) dans le monomère ou polymère (XVII) ou (XVIII) conduise à l'obtention de produits renfermant au moins une fonction époxy cycloaliphatique. Plus particulièrement, on préfère utiliser au moins 2 équivalents d époxy pour 1 équivalent d'acide carboxylique.

Les composés de formule (XVII) sont choisis parmi:
- les acides mono- ou polycarboxyliques dont A₁ constitue le squelette hydrocarboné et dont plusieurs exemples ont été cités ci-dessus à l'occasion de la définition de A₁.
- les polyesters à terminaison carboxy dont A₁ constitue la séquence polyester et dont plusieurs exemples ont été cités ci-dessus à l'occasion de la définition de A₁. Leur obtention est bien connue de l'homme de métier et leur indice d'acide varie le plus souvent de 5 à 450 mgKOH/g environ.
- les polyuréthannes renfermant une fonction carboxy dont A₁ constitue la séquence centrale, dont plusieurs exemples ont été cités ci-dessus à l'occasion de la définition de A₁ et dont l'obtention est bien connue de l'homme de métier.

Les composés de formule (XVIII) sont, de manière bien connue de l'homme du métier, obtenus par homopolymérisation ou copolymérisation radicalaire d'au moins un ester acrylique ou méthacrylique et. le cas échéant, d'au moins un monomère vinylaromatique, en présence d'au moins un initiateur de radicaux libres de type peroxyde organique (tel que le peroxyde de benzoyle) ou compose diazoique tel que le 1,1'-azo-bis(2-méthylbutyronitrile), et d'au moins un agent de transfert de chaine comprenant une fonction acide carboxylique ou bien en présence d'un initiateur de type diazoïque comportant une fonction acide carboxylique tel que le 4,4'-azobis(acide 4-cyanovalérique) ou bien ces deux composes utilisés en combinaison. Comme exemples d'agents de transfert de chaine, on peut citer des acides mercaptocarboxyliques ayant de 2 à 16 atomes de carbone tels que l'acide mercaptoacétique, les acides mercapto-2 et mercapto-3 propioniques, l'acides mercapto-2 benzoïque. i acide mercapto-succmique, l'acide mercaptoisophtalique et similaires. L'homme du métier sait bien régler le poids moléculaire des polymères de formule (XVIII) par le choix, en nature et en quantité. de l'initiateur de radicaux libres et de l'agent de transfert de chaine ainsi que des conditions. notamment de température, de la polymérisation. Pour la mise en oeuvre de la présente invention, on préfère généralement choisir des polymères (XVIII) de poids moléculaire allant de 5000 à 20000 environ.

Les composés de formule (XIX) mis en oeuvre dans le procédé selon l'invention sont bien connus de l'homme du métier et peuvent être choisis notamment parmi:
- les diépoxydes d'esters cycloaliphatiques d'acides dicarboxyliques tels que ceux de formule (XX) 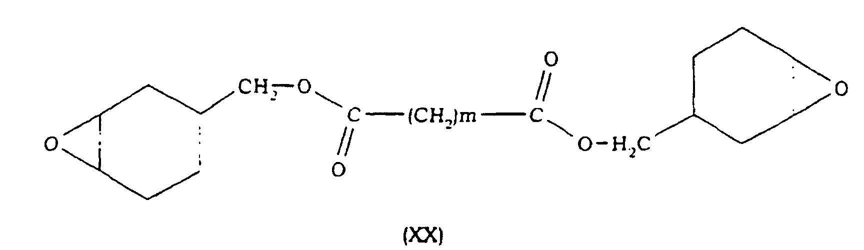 dans laquelle m est un nombre entier de 0 à 20 environ, de préférence de 1 à 6. et chacun des atomes de carbone des cycles aliphatiques peut porter un ou deux substituants de préférence hydrocarbonés et de préférence peu encombrés stériquement tels que des radicaux alkyles linéaires ayant de 1 à 9 atomes de carbone environ. Des exemples spécifiques de tels diépoxydes de formule (XX) sont les bis(3,4-époxycyclohexylméthyl)oxalate, bis(3,4-époxycyclohexylméthyl)adipate, bis(3,4-époxy-6-méthylcyclohexyl- methyl)adipate, et bis(3,4-époxycyclohexylméthyl)pimelate.
- les 3,4-epoxycyclohexylméthyl-3,4-époxycyclohexane carboxylates de formule (XXI) 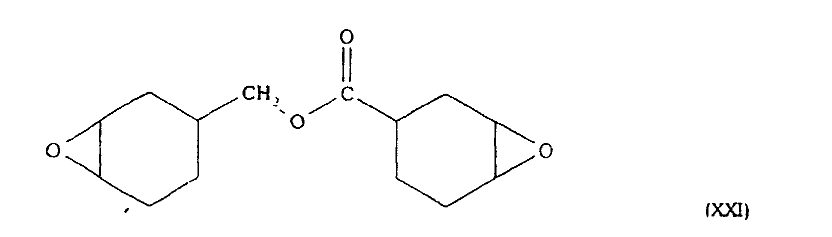 dans laquelle chacun des atomes de carbone des cycles aliphatiques peut porter un ou deux substituants de préférence hydrocarbonés et de préférence peu encombrés stériquement tels que des radicaux alkyles linéaires ayant de 1 à 9 atomes de carbone. Des exemples spécifiques de tels diépoxydes de formule (XXI) sont les 3,4-époxycyclohexylméthyl-3,4-époxycyclohexane carboxylate, 3,4-époxy-1-méthylcyclohexylméthyl-3,4-époxy-1-méthylcyclohexane carboxylate, 6-méthyl-3,4-poxycyclohexylméthyl-6-méthyl-3,4,-epoxycyclohexane carboxylate, 3,4-époxy-3-méthylcyclohexylméthyl-3,4-époxy-3-méthylcyclohexane carboxylate, 3,4-époxy-5-méthylcyclohexylméthyl-3,4-époxy-5-méthylcyclohexane carboxylate.
- les diépoxydes de formules (XXII) 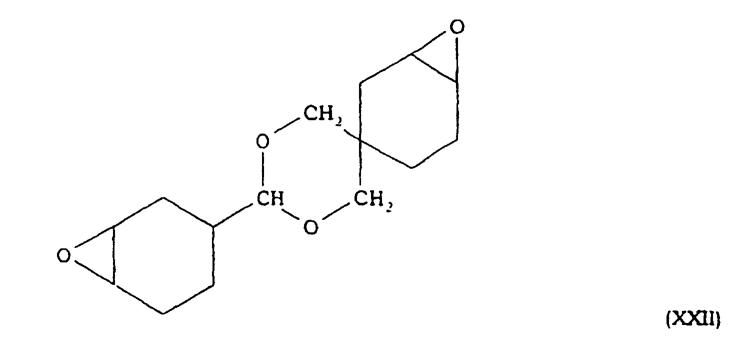 dans laquelle chacun des atomes de carbone des cycles aliphatiques peut porter un ou deux substituants de préférence peu encombrés stériquement tels que des radicaux alkyles linéaires ayant de 1 à 9 atomes de carbone environ ou des atomes d'halogène;
- le 1,2,5,6-diépxy-4,7-méthano-perhydroindéne de formule (XXIII) 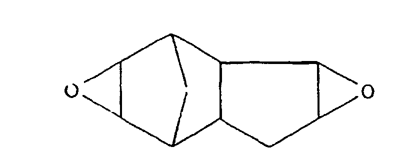
- le 2-(3,4-époxycyclohexyl)-3',4-époxy-1,3-dioxane-5-spirocyclohexane de formule 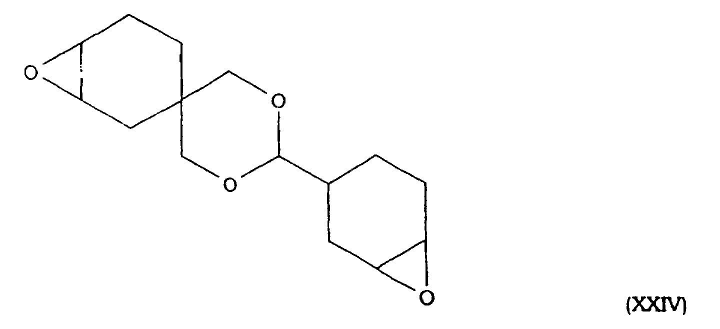
- le 1,2-éthylènedioxy-bis(3,4-époxycyclohexylméthane) de formule 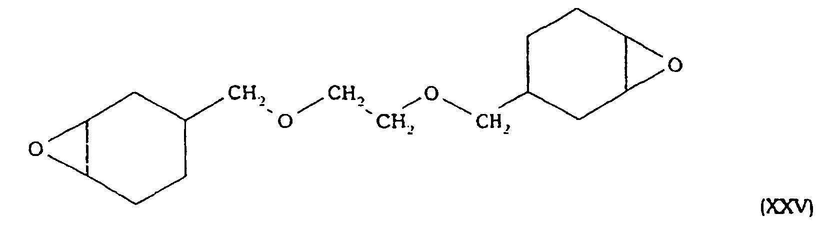
- le di-(2,3-époxycyclopentyl)éther de formule (XXVI) 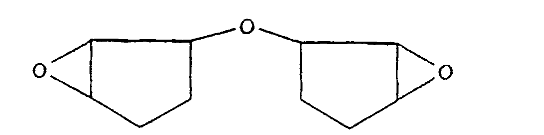
- les diépoxycyclohexanes de formules 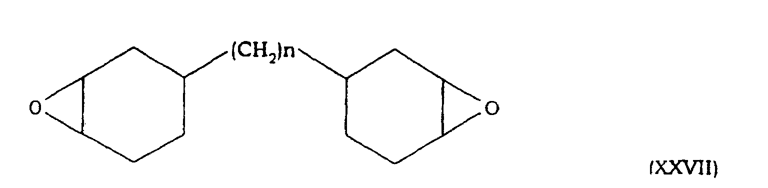 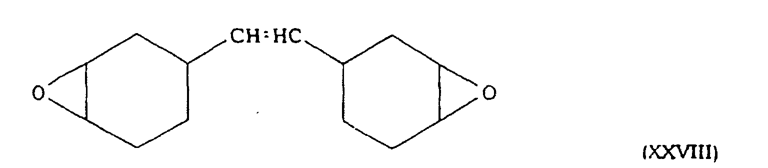 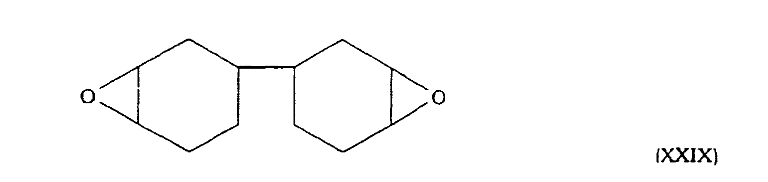
- les diépoxycyclohexanes porteurs de silicium de formules 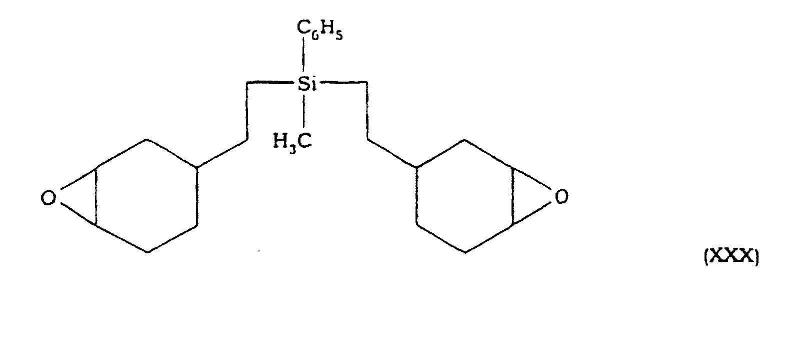 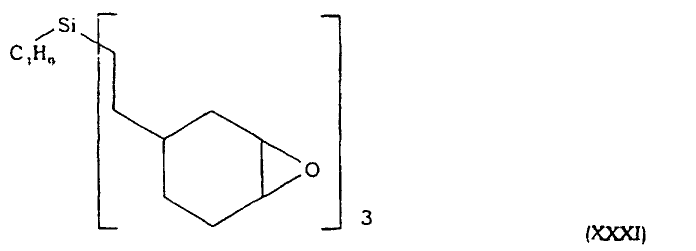 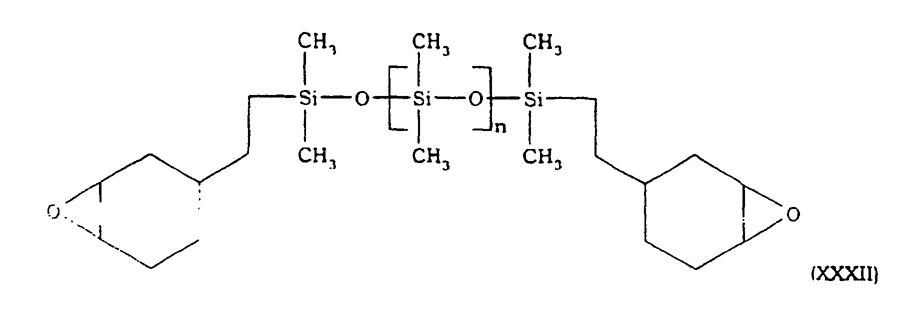 dans laquelle n est un nombre entier de 0 à 10 environ 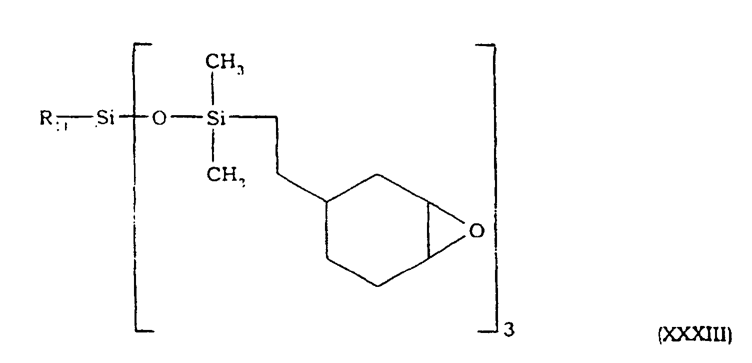 dans laquelle R₁₁ est choisi parmi les radicaux alkyles ayant de 1 à 8 atomes de carbone (notamment le groupe méthyle) et les radicaux aryles ayant de 6 à 9 atomes de carbone (notamment le groupe phényle), et

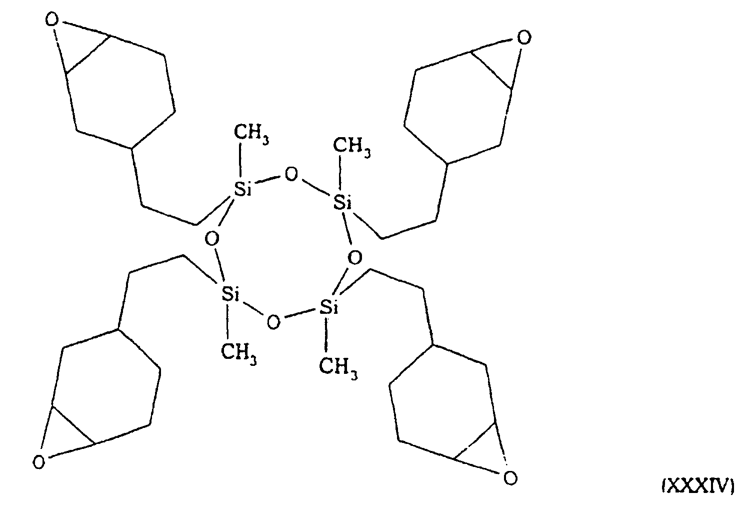

Les composés de formules (XXX) à (XXXIV) peuvent être préparés notamment selon l'enseignement de Crivello, J.V.; Lee. J.L.; J. Polym. Sci., Poly. Chem 1990, Vol. 28. 479-503 et Crivello. J.V. Adv. in Polym. Sci., 1984, 62, 1.

La reaction du procédé selon l'invention pour l'obtention des composés de formule (I) et (II) est effectuée de préférence en présence d'au moins un solvant et avec application de la chaleur. On choisira de préférence comme solvant un composé capable de procurer une bonne solvatation du groupe carboxyle présent dans les composés de formule (XVII) et (XVIII). A titre d'exemple on citera les hydrocarbures aromatiques tels que le toluène et le xylene. La température réactionnelle sera naturellement choisie en fonction de la température d'ébullition du solvant retenu et sera le plus souvent comprise dans une gamme allant de 100°C à 150°C environ. Le degré d'avancement de la réaction peut être suivi par tout moyen connu, tel que notamment la mesure de l'indice d'acide du milieu réactionnel. On considère en général la réaction comme achevée lorsque cet indice devient inférieur ou égal à 5 mg KOH/g.

La réaction du procédé selon l'invention peut, si désiré, être accélérée par la présence d'une quantité catalytique d'un composé connu pour faciliter et promouvoir la réaction entre la fonction époxyde et la fonction acide carboxylique. Comme tels composés on peut citer d'une part des catalyseurs à base de métal de transition tel que le chrome, par exemple le chlorure ou un tricarboxylate de chrome trivalent, le cas échéant dilué dans un ou plusieurs esters d'acide phtalique et d'alcools ayant de 6 à 20 atomes de carbone environ. Comme tricarboxylate de chrome III, on peut citer notamment le butyrate, le pentanoate, l'hexanoate, l'éthyl-2-hexanoate, le décanoate, l'oléate, le stéarate, le tolerate, le crésylate, le benzoate, les alkylbenzoates, les alkoxybenzoates et les naphténates. Comme catalyseur on peut également citer des halogénures d ammonium quaternaires tels que le chlorure de benzyltriméthyl ammonium ou encore le chlorure ferrique. Par quantité catalytique on entend généralement l'emploi d'une proportion allant jusqu à environ 0.2% en poids de ce promoteur par rapport à la somme du monomère ou polymère de formule (XVII) ou (XVIII) et du diepoxyde cycloaliphatique de formule (XIX).

Selon encore un autre aspect. la présente invention concerne la polymérisation sous irradiation d un monomère, oligomère ou polymère de formule (I) ou de formule (II). En effet, compte tenu de l'existence de fonctions époxy libres dans le groupe R₂ de ces composés, ceux-ci se prètent bien à la polymérisation sous irradiation, pour laquelle ils montrent une aptitude particulière à des vitesses élevées et à procurer des revêtements de performances supérieures en ce qui concerne notamment la durabilité, la porosité, la résistance aux agressions chimiques (telles que dues aux solvants, détergents, nettoyants et décapants) et l'aspect de surface.

Ces resultats surprenants sont obtenus en polymerisant sous irradiation une composition comprenant au moins un monomère, oligomere ou polymère de formule (I) ou de formule (II) en présence d'au moins un photoinitiateur de polymérisation cationique et le cas écheant en présence d'un autre composé cationiquement polymérisable en présence de ce photoinitiateur.

De nombreuses familles de composés connus en tant que photoinitiateurs cationiques peuvent être utilisées pour le procédé de polymérisation selon l'invention. Parmi ces composés on peut citer des sels de diazonium aromatiques d'halogénures complexes tels que notamment les tétrachloroférrates (III) de 2,4-dichlorobenzenediazonium, de p-nitrobenzenediazonium et de p-morpholinobenzenediazonium, les hexachlorostannates (IV) de 2,4-dichlorobenzenediazonium et de p-nitrobenzenediazonium, le 2,4-dichlorobenzenediazonium tetrafluoroborate, les hexafluorophosphates de p-chlorobenzenediazonium, de 2,4-dichlorobenzenediazonium, de 2,4,6-trichlorobenzenediazonium, de 2,4,6-tribromobenzenediazonium, de p-nitrobenzenediazonium, de o-nitrobenzenediazonium, de 4-nitro-o-toluènediazonium, de 2-nitro-p-toluénediazonium et de 6-nitro-2,4-xylènediazonium.

On peut également citer des sels complexes d'iodonium aromatiques de formule 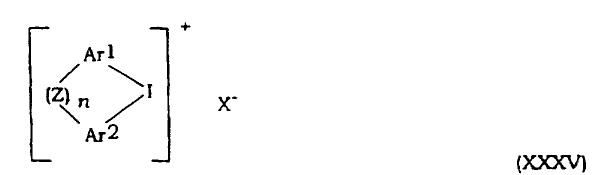 dans laquelle
- Ar₁ et Ar₂ sont des groupes aromatiques différents ou identiques ayant de 4 à 20 atomes de carbone tels que phényle, thienyle, furanyle et pyrazolyle. Les groupes Ar₁ et Ar₂ peuvent le cas échéant posséder un ou plusieurs noyaux benzo accoiés, par exemple naphtyle, benzothiényle, dibenzothiényle, benzofuranyle ou dibenzofuranyle, et/ou un ou plusieurs substituants tels q halogène, nitro, hydroxyle, carboxyle, anilino, N-alkylanilino, ester, sulfoester, amido, carbamyle, sulfanyle, alcoxy, alkyle, aryle, aryloxy, arylsulfonyl ou perfluoroalkyle.
- Z est choisi parmi les atomes d'oxygène et de soufre, la liaison carbone-carbone, les groupes sulfone, carboxyle, sulfoxyde, amine, et les groupes de formule (XXXVI) 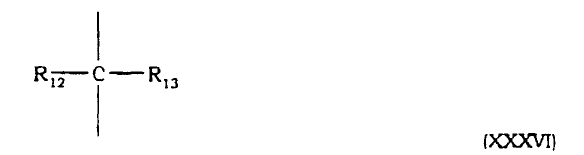 dans laquelle
   - R₁₂ et R₁₃ sont choisis parmi l'atome d'hydrogène, les radicaux alkyles comprenant de 1 à 4 atomes de carbone, et les radicaux alcényles comprenant de 2 à 4 atomes ce carbone,
   - n est egal à 0 ou 1,
   - X- est un anion complexe halogéné choisi parmi le tetrafluoroborate. l'hexafluorophosphate, l'hexafluoroarsenate, l'hexachloroantimonate et l'hexafluoroantimonate.

Des exemples de tels sels d'iodonium sont notamment les tetrafluoroborates de diphényliodonium, de di(4-méthylphényl)iodonium, de phényl-4-méthylphényliodonium, de di(4-heptylphényl)iodonium, de di(naphthyl)iodonium et de di(4-phenoxyphényl)iodonium tetrafluoroborate phényl-2-thienyliodonium, 2,2'-diphényliodonium, les hexafluorophosphates de di(3-nitrophényl)iodonium, de di(4-chlorophényl)iodonium, de di(4-trifluorométhylphényl) iodonium tetrafluoroborante diphényliodonium, de di(2,4-dichlorophényl)iodonium, de di(4-bromophényl)iodonium, de di(4-méthoxyphényl)iodonium, de di(3-carboxyphényl)iodonium, de di(3-methoxycarbonylphényl)iodonium, de di(3-méthoxysulfonyl phényl)iodonium, di(4-acetamidophényl)iodonium et de di(2-benzothienyl)iodonium, le di(4-méthylphényl)iodonium hexafluorophosphate diphényliodonium hexafluoroarsenate, et le 3,5-diméthyliodonium hexafluoroantimonate.

Comme photoinitiateurs cationiques utilisables on peut encore citer des borates d'onium dont la partie cationique comprend un sel d'onium tel que décrit dans les brevets US-A-4.026.705; 4.032.673: 4.069.056; 4.136.102 et 4.173.476 ou bien un sel d'oxoisothiochromanium tel que décrit dans la demande de brevet WO-A-90/ 11303 ou encore un sel organométallique tel que décrit dans les brevets US-A-4.973.722 et 4.992.572 et dans les demandes de brevet EP-A-203.829; EP-A-323.584 et EP-A-354.181. et dont la partie borate anionique possède la formule 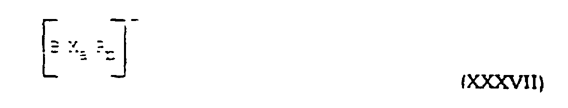 dans laquelle a et b sont des nombres entiers allant de 0 à 4 avec a + b = 4; chaque X est un atome d'halogène avec a = 0 à 3 ou un groupe fonctionnel OH avec a = 0 à 2; les symboles R, qui peuvent être identiques ou différents, sont chacun:
- un radical phényle substitué par au moins un groupe accepteur d'électrons ou par au moins deux atomes d'halogène lorsque la partie cationique est un sel d'onium d un élément des groupes 15 à 17 de la Table Périodique (Chem. & Eng. News, vol. 63. No. 5, 26), ou bien
- un radical phényle substitué par au moins un groupe accepteur d'électrons ou un atome d'halogene lorsque la partie cationique est un sel organométallique d'un métal des groupes 4 à 10 de la Table Périodique, ou bien
- un radical aryle contenant au moins deux cycles aromatiques, le cas échéant substitué par au moins un groupe accepteur d'électrons ou un atome d'halogène, quelle que soit la partie cationique.

Comme exempies de tels composés on peut citer notamment les tetrakis (pentafluorophényl)borates de diphényliodonium, de (4-octyloxyphényl)phényliodonium, de (dodécylphényl)iodonium, de (η⁵-Cyclopentadienyl)(h6-cumene)Fe⁺, de (η⁵-Cyclopentadienyl)(η⁶-toluène)Fe⁻ et de (η⁵-Cyclopentadienyl)(η⁶-méthylnaphtalène)Fe⁺.

On peut encore citer comme photoinitiateurs cationiques utilisables des seis complexes de sulfonium aromatiques tels que ceux de formule (XXXVIII) 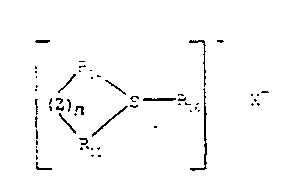 dans laquelle
- R₁₄, R₁₅ et R₁₆, sont identiques ou différents et sont choisis parmi les groupes aromauques avant de 4 à 20 atomes de carbone (tels que définis précédemment pour Ar₁ et Ar₂) et les groupes alkyles ayant de 1 à 20 atomes de carbone, à la condition que l'un au moins de R₁₄, R₁₅ et R₁₆ soit aromatique,
- Z est défini comme dans la formule (XXXVI)
- n a pour valeur 0 ou 1, et
- X est un anion complexe halogéné choisis parmi le tetrafluoroborate. l'hexafluorophosphate, l'hexafluoroarsenate, l'hexachloroantimonate et l'hexafluoroantimonate,

Comme exemples de ces sels on peut citer notamment les tetrafluoroborates de triphénylsulfonium, de méthyldiphénylsulfonium, de 4-butoxyphényldiphénylsulfonium, de 4-acétoxy-phényldiphénylsulfonium, de di(méthoxynaphthyl)méthylsulfonium, de 4-acétamidophényldiphénylsulfonium, de trifluorodiphénylsulfonium, de (10-phényl-9-oxothioxanthenium) et de (5-méthyl-10-oxothiaanthrenium), les hexafluorophosphates de diméthylphénylsulfonium, de triphénylsulfonium, de tritolysulfonium, de tris(4-phénoxyphényl)sulfonium, de tris(4-thiométhoxyphényl)sulfonium, de di(carbométhoxyphényl)méthylsulfonium, de diméthylnaphthylsulfonium, de phénylméthylbenzylsulfonium, de (10-méthylphénoxathiinium), de (10-phényl-9,9-diméthylthioxanthenium), de (10-phénylthioxanthenium), de (5-méthylthianthrenium) et de (5-méthyl-10,10-dioxothianthrenium), les hexafluoroantimonates de triphénylsulfonium, d'anisyldiphénylsulfonium, de 4-chlorophényldiphénylsulfonium, de di(méthoxysulfonylphényl)méthylsulfonium et de méthyl(N-méthylphénothiazinyl)sulfonium, ies hexafluoroarsenates de diphénylnaphthylsulfonium et de di(4-éthoxyphényl)méthylsulfonium.

Comme photoinitiateurs cationiques utilisables on peut encore citer des seis d onium du groupe VIa de formule générale (XXXIX): 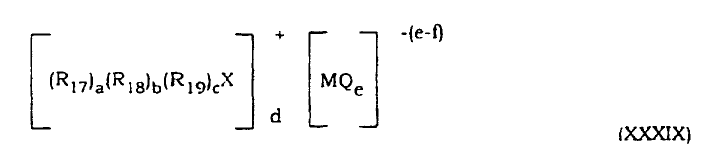 dans laquelle:
- R₁₇ est un groupe aromatique monovalent ayant de 6 à 13 atomes de carbone et le cas échéant substitué.
- R₁₈ est un groupe aliphatique monovalent ayant de 1 à 8 atomes de carbone choisi parmi les groupes alkyle, cycloalkyle et alkyle substitué,
- R₁₉ est un groupement organique polyvalent formant une structure hétérocyclique ou à anneaux condensés choisie parmi les groupes aliphatiques ou aromatiques,
- X est choisi parmi le soufre, le sélénium et le tellure,
- M est un métal ou métalloïde.
- Q est un halogène.
- a est un nombre entier allant de 0 à 3,
- b a une valeur comprise entre 0 et 2,
- c vaut soit 0, soit 1.
- la somme de a + b + c est égale à 3 ou bien à la valence de X
- d = e - f
- f a ia valeur de la valence de M et est un nombre entier allant de 2 à 7,
- e est pius grand que f et est un nombre entier allant jusqu'à 8.

M peut être un métal de transition tel que l'antimoine, le fer, l'étain, le bismuth, l'aluminium, le gallium, l'indium, le titane, le zirconium, le scandium, le vanadium, ie chrome, ie manganese et le césium, un métal rare comme un lanthanide (par exemple le cérium) ou un actinide (comme le thorium ou l'uranium) ou un métalloïde comme le bore, le phosphore et l'arsenic. Les anions complexes [MQₑ]^{-(e-f)} sont par exemple BF₄⁻, PF₆⁻, AsF₃⁻, SbF₆⁻, FeCl₄⁻, SnCl₆⁻, SbCl₆⁻, BiCl₅⁻⁻, AlF₆³⁻, TiF₆⁻⁻ et ZrF₆⁻.

Une autre famille de photoinitiateurs cationiques utilisables est constituée par les sels comple les aromatiques de métau de transition de formule générale (XL): 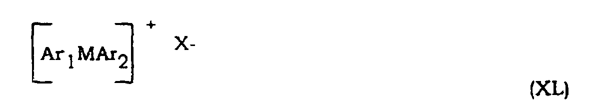 dans laquelle:
- M est un metal de transition choisi parmi l'antimoine, le fer, l'étain, le bismuth. l'aluminium, le titane, le zirconium, le vanadium, le chrome, le manganèse et le césium,
- Ar₁ et Ar₂ sont des groupes définis comme dans la formule (XXXV), et
- X est un anion complete halogéné choisi BF₄⁻, PF₆⁻, AsF₃⁻, SbF₆⁻, FeCl₄⁻, SnCl₆⁻, SbCl₆⁻ BiCl₅⁻⁻, AlF₆³⁻, TiF₆⁻⁻ et ZrF₆⁻.

Comme exemple de tels composés, on peut citer notamment le (η⁵-2,4-cyclopentadiene-1-yl)[(1,2,3,4,5,6-η)-(1-méthyléthyl)-benzène]fer(1+)-hexafluorophosphate(1-) de formule (XLI):

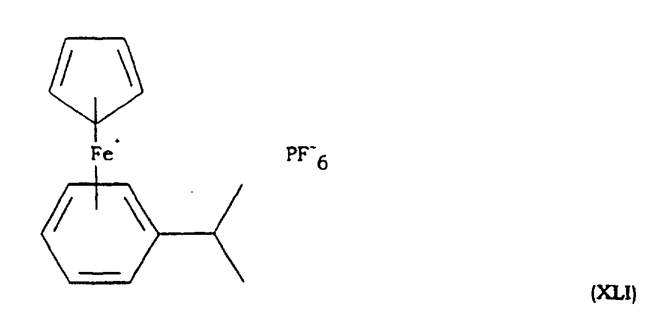

Une autre famille de photoinitiateurs cationiques utilisables est constituée par les composés de formule (XLII): 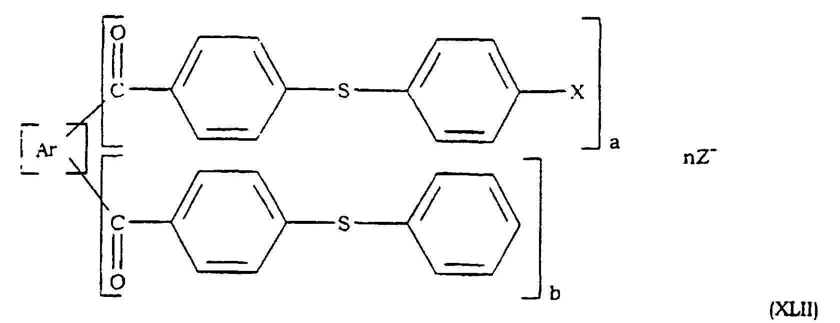 dans laquelle
- Ar est un groupe aromatique tel que phényle, biphényle, naphthyle, le cas échéant substitué.
- X est un groupe bisphényl-sulfonio de formule 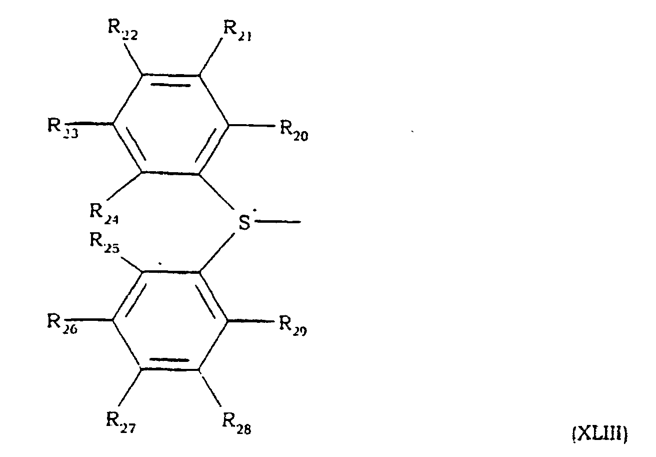 dans laquelle R₂₀ à R₂₉ est chacun indépendamment choisi parmi les atomes d'hydrogène et d'halogène, les groupes nitro, alcoxy, alkyle, phényle, phénoxy, alkylthio, phénylthio, benzyloxy et hydroalkyle,
- a est un nombre de 1 à 4, b est un nombre de 0 à 3, a + b est un nombre de 1 à 4, n est un nombre de 1 à 4, et
- Z est un halogénure de formule

   MQₘ(OH)₁ (XLIV)

   dans laquelle M est choisi parmi les atomes de bore. de phosphore, d'arsenic et d'antimoine, Q est un halogene, m est un nombre de 3 à 6, l est 0 ou 1 et m - 1 est un nombre de 4 à 6.

Comme indique précédemment, la polymérisation sous irradiation du composé de formule (I) ou (II) peut être effectuee en présence d'un autre composé polymérisable cationiquement au moyen du même photoinitiateur: c'est-à-dire dans ce cas le procédé selon l'invention consiste à polymériser sous irradiation un mélange comprenant d'une part (A) un composé de formule (I) ou (II) et d'autre part (B) un tel autre composé. Afin de conserver les avantages éminents apportés, sur le plan de la vitesse de polymérisation et des performances des produits polymérisés obtenus il est préférable qu'un tel mélange comprenne au moins 20% en poids du composé (A) et donc au plus 80% en poids du composé (B).

Des catégories variées de composés (B) peuvent convenir à la polymérisation sous irradiation d'une telle composition. Leur détermination dépend essentiellement d'une part de leur aptitude à la polymèrisation sous irradiation en présence du photoinitiateur cationique choisi et d autre part de leur miscibilité avec le composé (A) de formule (I) ou (II) retenu. A titre d'exemples non exhaustifs de tels composés (B) on peut donc citer:
- des monoepoxydes non cycloaliphatiques, par exemple des monoépoxydes aliphatiques mono- ou multifonctionnels, tels que notamment les acrylates et méthacrylates de glycidyle, de (norbornyloxy-2)-2 éthyle, de (diméthanodécahydronaphtyloxy-2)2 éthyle, de 4,5-époxypentyle, de 5,6-époxyhexyle, de 6,7-époxyheptyle, de 7,8-époxyoctyle, de 8,9-époxynonyle, de 9,10-époxydécyle, de 11,12-époxydodécyle, de 2,3-époxybutyle, de 3-phényle, 2,3-époxypropyle et d'octahydro-2,5-méthano-2H-undéno [1,2-b] oxyrényle,
- des monoépoxydes cycloaliphatiques mono- ou multifonctionnels tels que les acrylates et méthacrylates d'hydroxy-5(6) [époxy-2,1' éthyle]-2 bicyclo [2,2,1] heptane, de 3,4-époxycyclohexylméthyle, de 2-(1,2-époxy-4,7-méthano-perhydroiden-5(6)-ylioxyéthyle, de 5,6-époxy-4,7-méthano-perhydroiden-2-yle, de 1,2-époxy-4,7-méthano-perhydroiden-5-yle, de 2,3-époxycyclopentenylméthyle et de polycaprolactone 3,4-epoxycyclohexylméthylée de formule: 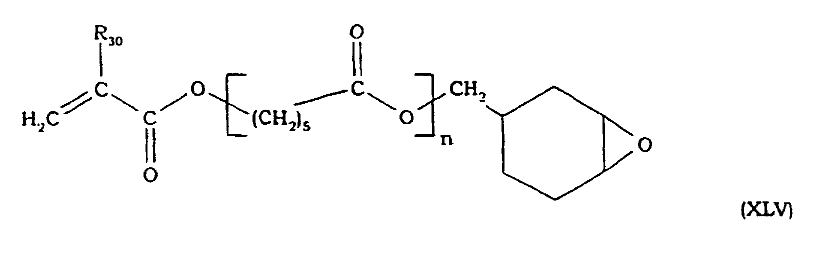 dans laquelle R₃₀ est choisi parmi l'hydrogène et le radical méthyle et n est un nombre entier allant de 1 à 10 environ,
- le monoépoxyde de 4-vinyl cyclohexéne de formule 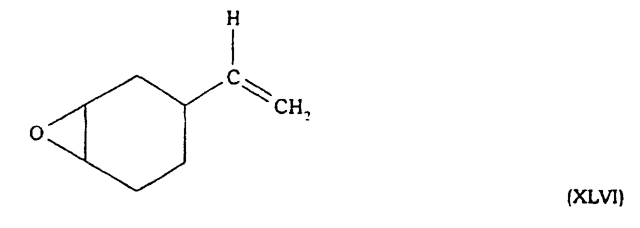 le monoépoxyde de vinyl norbornène de formule 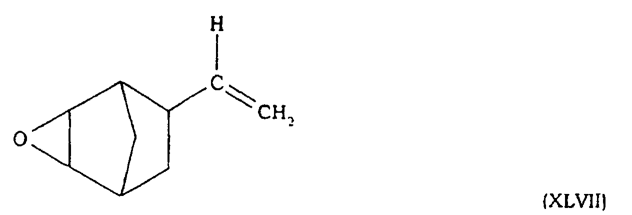 le monoepoxyde de limonéne de formule 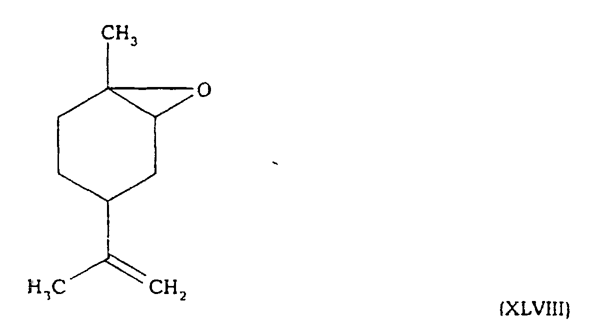 et le diépoxyde de limonène de formule 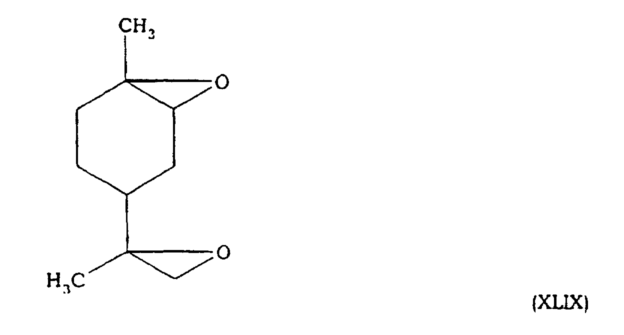
- des diépoxydes aliphatiques tels que des diglycidyléthers d'alcools polyhydriques de formule générale 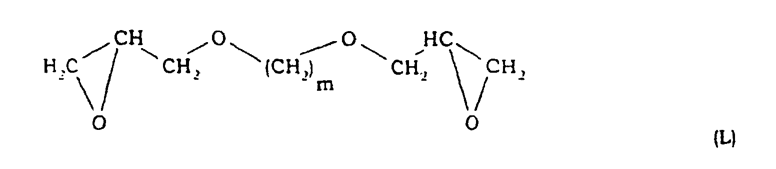 dans laquelle m est un nombre entier allant de 2 à 12, en particulier le diglycidyléther du 1,4-butanediol (1,4-bis(2,3-époxypropoxy)-butane), ou encore le diglycidyléther de diéthylène glycol (bis[2-(2,3-époxypropoxy)-éthyl]éther) de formule 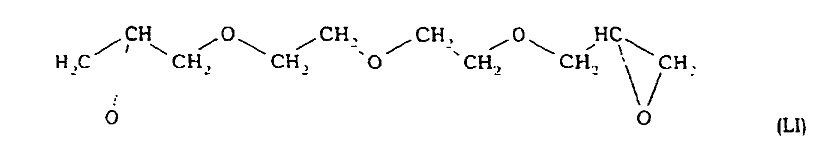 ainsi que les 2,3-bis(2,3-époxypropoxy)-1-propanol et 1,3-bis(2,3-époxypropoxyl-2-propanol.
- des polyglycidyléthers de phénols polyhydriques possédant au moins un noyau aromatique ainsi que leurs adducts avec un oxyde d'alkylène, par exemple ceux produits par la reaction de composés de bisphénol tels que le bisphénol A. le bisphénol F et le bisphenol S ou leurs adducts d oxyde d'éthylène, d'oxyde de propylène ou d oxyde de butylène avec l'épichlorhydrine, les résines epoxy de type novolaque, crésol-novolaque ou bromophénol-novolaque, et le triglycidyléther de trisphénolméthane. Des structures genérales de ces résines polyépoxydées sont notamment représentées par les iormuies 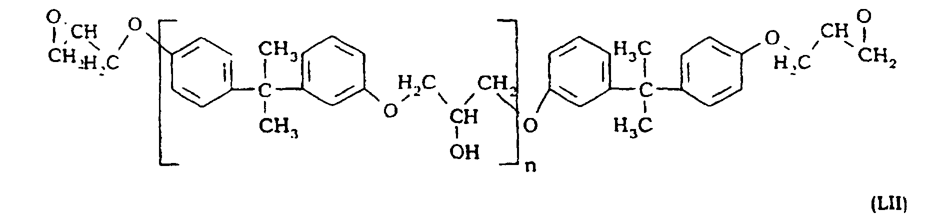 (pour les dérivés de bisphénol A), et 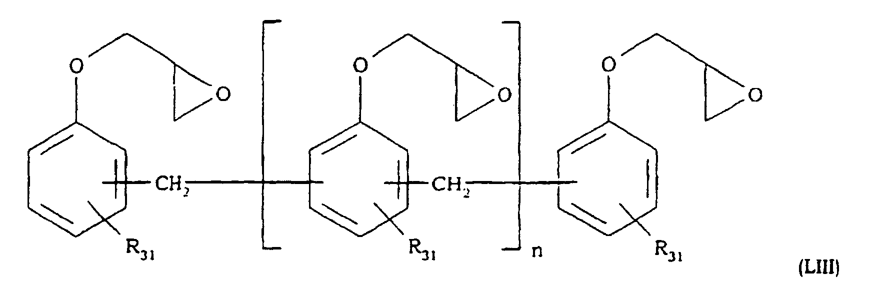 dans laquelle R₃₁ est choisi parmi l'hydrogène et le groupe méthyle (pour les résines époxy-phénol et époxy-crésol novolaques).
- des résines amino-glycidylées aromatiques et hétérocycliques telles que des résines dérivées de la tétraglycidylméthylènedianiline de formule 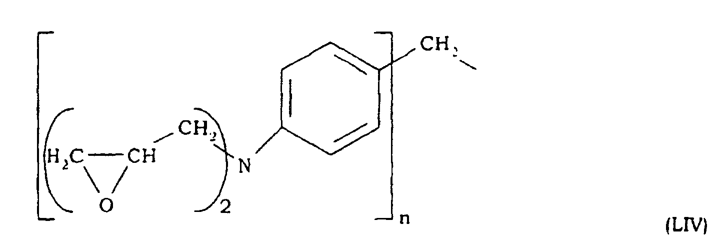
- des résines dérivées du triglycidyl-p-aminophénol, des résines à base de triazines et des résines époxy-hydantoïne de formule 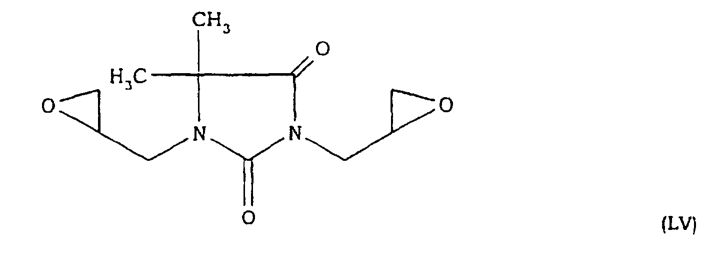
- des adducts d'époxy-alcools alicycliques et d'isocyanate (méth)acrylique ou de (méth)acrylate d'isocyanatoéthyle ou de m-isopropényl-α,α-diméthylbenzylisocyanate tels que la N-(3,4-époxycyclohexyl)méthylcarbonyl(méth)acrylamide) la N-(5,6-époxy-4,7-méthano-perhydroinden-2-yl)oxycarbonyl(méth)acrylamide et l'adduct de la polycaprolactone 3,4-époxycyclohexylméthylée et du (méth)acrylisocyanate de formule 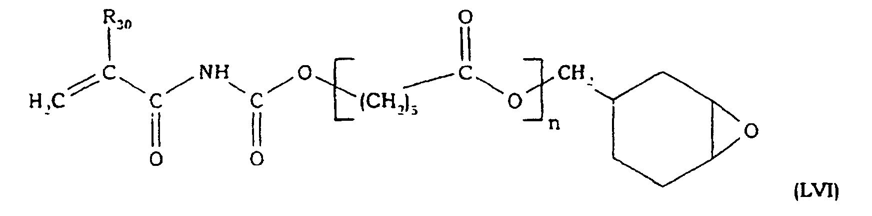 dans laquelle R₃₀ est choisi parmi l'hydrogène et le radical méthyle et n est un nombre entier allant de 1 à 10.
- des dénvés époxydés de composés naturels insaturés tels que par exemple des huiles de soja epoxydées et de polymères synthétiques insaturés, tels que le polybutadiène époxydé.
- des vinyléthers aliphatiques tels que le triéthyléne glycol divinyl éther et l'hydroxybutylvinyléther, des vinyléthers cycliques tels que le 1,4-cyclohexanediméthanol divinyléther, les oligoméres de l'acroléine, le 4-méthyldihydropyrane et les dérivés du 3,4-hydropyrane-2-méthanol, ainsi que des alkylvinyléthers.
- des propényléthers tels que le propényléther du carbonate de propylène et des composés de formule

   A(OCH=CHCH₃)ₙ (LVII)

   dans laquelle n est un nombre entier allant de 1 à 6 et A est choisi parmi des éthers cycliques, des polyéthers et des alcanes linéaires, ramifiés ou cycliques possédant de 2 à 20 atomes de carbone. Des exemples de tels composés comprennent: 1,2-dipropenoxyethane; 1,4-dipropenoxybutane; 1,6-propenoxyhexane: 1,3-dipropenoxypropane; 1,4-cyclohexanediméthanol dipropenyl éther; 1,4-cyclohexanedipropenyl éther: 1,2-dipropenoxypropane; 1,10-dipropenoxydecane; 1,8-dipropenoxy-octane; 1,2,3-tripropenoxypropane; 1,2,3,4-tetrapropenoxybutane; sorbitol hexapropenyl éther; triméthylolpropane tripropenyléther; pentaerythritol tetrapropenyl éther; 1,2-dipropenoxycyclopentane; 1,3-dipropenoxyperfluoropropane; diethyleneglycol dipropenyl éther; tetraéthyléneglycol dipropenyl éther, et 3,4-dipropenoxytetrahydro-furane
- des oxétanes tels que le 3,3-bischlorométhyloxétane, des 4,4-dialkyl-2-alcoxyoxétanes, des composés de formule 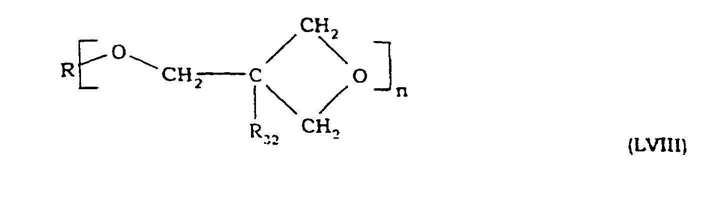
dans laquelle R est un groupe arylène (par exemple phénylène), R₃₂ est choisi parmi l'hydrogène et les radicaux méthyle et éthyle et n est un nombre entier au moins égal à 2, ainsi que des oxètanes substitués tels que ceux divulgués dans le brevet US-A-5463084.

La quantité de photoinitiateur cationique à utiliser pour la mise en oeuvre du procédé de polymérisation par irradiation est à rapporter à la quantité de matière organique polymérisable, c'est-à-dire au poids combiné du composé (A) de formule (I) ou (II) et du composé (B) éventuellement mélangé à ce dernier. Une proportion usuelle de photoinitiateur(s) est comprise entre environ 0,1% et environ 10% en poids de la matière organique polymérisable, de préférence d'environ 1% à 5% en poids de ladite matière.

Selon un aspect particulier de la présente invention, la composition soumise à polymérisation sous irradiation peut en outre comprendre au moins un composé, monomère ou oligomere, tel qu'un uréthane-acrylate, un polyester-acrylate ou un époxy-acrylate. capable de durcir sous irradiation par un mécanisme de réticulation duale ou hybride. Dans ce cas. deux mécanismes de réticulation différents ont lieu soit simultanément, soit successivement: à titre d'exemple, on peut citer des composés capables de durcir par polymérisation radicalaire. Dans le cas où le photoinitiateur cationique est un sei de sulfonium aromatique, un initiateur radicalaire n est pas nécessaire, car le photoinitiateur fournit en même temps des cations et des radicaux libres lors de sa décomposition. Alternativement il est possible de mettre en oeuvre la combinaison d un photoinitiateur cationique tel que décrit précédemment et d'un initiateur radicalaire, tel que, par exemple, la benzophénone, le benzyldiméthylacétal, la cyclohexylphénylcétone, les thioxanthones et tout autre initiateur utilisé pour provoquer une polymérisation radicalaire. Les proportions respectives des deux initiateurs à utiliser et leur quantité totale variera en fonction de la formulation de la composition et de l'application envisagée.

En outre pour certains usages particuliers des produits polymérisés obtenus par le procédé d'irradiation selon l'invention, il peut être utile d'ajouter à la composition polymérisable comprenant les composés (A) et (B) au moins un composé hydroxyle capable d'abaisser la viscosité de la composition (par exemple l'éthanol) et/ou au moins un composé polyhydroxylé ou un aldéhyde capable d'agir en tant qu'agent de transfert de chaine ou capable de flexibiliser la composition polymérisable. Parmi ces derniers composés on peut citer notamment l'éthylène glycol, le 1,4-butanediol, le benzaldéhyde, le pentaérythritol, le triméthylolpropane ainsi que des oligomères à terminaisons hydroxyles tels que des polyesters polyols, des polyéthers polyols, des polycaprolactones hydroxylées et des polybutadiènes hydroxylés.

Pour la mise en oeuvre du procédé de polymérisation selon l'invention, on pourra avoir recours à toute méthode normale de durcissement par rayonnement actinique. Le rayonnement peut être un rayonnement ionisant (corpusculaire ou non corpusculaire) ou non ionisant. On peut employer en tant que source appropriée de rayonnement corpusculaire, toute source qui émet des électrons ou des noyaux chargés. Un rayonnement corpusculaire peut être généré, par exemple, par des accélérateurs d'électrons (dans des conditions de voltage de 50 à 500 KeV environ et d'irradiation de 1 à 10 mégarads) tels que l'accélérateur de Van der Graff, et des éléments radioactifs, tels que le cobalt 60, le strontium 90, et analogues. On peut employer en tant que source appropriée de rayonnement non ionisant non corpusculaire, toute source qui émet un rayonnement dans le domaine de 10⁻³ à 2000 angströms. Les sources appropriées incluent les lampes à vide à rayons ultraviolets, telles que les arcs à xénon ou à krypton. On peut employer en tant que source appropriée de rayonnement non ionisant, toute source qui émet un rayonnement d'environ 150 nm à environ 500 nm. Les sources appropriées incluent les arcs à mercure. les arcs à charbon, les lampes a filament de tungstène, les lampes à rayons ultraviolets, les lampes excimères et les lasers, procurant une energie de préférence de 100 à 1000 mJ/cm² environ.

Lorsque les compositions de revêtement durcissables par rayonnement doivent être durcies par exposition à un rayonnement non ionisant, par exemple le rayonnement ultraviolet, un photoinitiateur ou photoactivateur autre que le photoinitiateur cationique décrit précédemment peut être ajouté à la composition. Des exemples bien connus incluent la 2,2-diéthoxy-acétophénone, la 2.3 ou 4-bromoacétophénone, le benzaldéhyde, la benzoïne, la benzophénone, le 9,10-dibromoanthracène, la 4,4'-dichloro-benzophénone, la 2,3-pentanedione, l'hydroxycyclohexylphénylcétone, et les (thio)xanthones. De tels photoinitiateurs sont généralement ajoutés dans des quantités allant de 0,1% à 10% environ en poids, et de préférence de 1% à 5% en poids, sur la base du poids de la composition polymerisable.

Selon encore un autre aspect particulier de la présente invention, la composition peut aussi polymériser selon le mécanisme dit de "réticulation dans l'obscurité". Dans ce cas, contrairement à la polymérisation initiée radicalairement, la polymérisation continue après que l'exposition au rayonnement ait cessé. Ce mécanisme peut être utile dans certains cas, par exemple pour améliorer la réticulation dans les pores de substrats poreux, pour les adhésifs, les revêtements pour l'électronique, etc.

La composition soumise au procédé d'irradiation selon l'invention peut, outre le composé (A) ainsi que le cas échéant le composé (B), l'agent de transfert de chaine ou de flexibilisation, le photoinitiateur complémentaire (dans le cas du rayonnement ultraviolet) et le photoactivateur, comprendre:
- au moins un agent mouillant ou modificateur de surface, capable d'améliorer les propriétés d'étalement du film polymère, tel qu'un produit siliconé ou fluoré ou un polyether ou tout autre composé connu pour apporter cette propriété spécifique,
- au moins un promoteur d'adhésion connu en soi.
- au moins une charge minérale (telle que notamment le kaolin, la silice, le sulfate de baryum, le carbonate de calcium ou le talc) ou organique habituellement utilisée dans des compositions de revêtement radioréticulables,
- au moins un pigment minéral, empâté ou non dans un liant polymère organique, ou colorant organique, et
- le cas échéant, un ou plusieurs additifs choisis dans les catégories des agents antistatiques, des antimousses, des agents mouillants et des agents épaississants.

Les divers additifs éventuels énumérés ci-dessus seront utilisé dans le cadre de la présente invention dans les proportions déjà bien connues dans les techniques de revêtement par irradiation.

Les compositions de résine utilisées dans le procédé de polymérisation par irradiation selon l'invention peuvent être appliquées sous forme de revétement sur un support par toute méthode telle que le revêtement à la brosse, le revêtement par pulvérisation, le revêtement par la technique du rideau, etc. Le cas échéant, et en fonction des besoins de l'application précise envisagée, le support peut être soumis à une étape de traitement antérieur ou postérieur à l'irradiation telle qu un traitement thermique destiné à accélérer ou à compléter la réaction de polymérisation de la composition. Dans ce dernier cas, la température et la durée du post-traitement thermique seront choisies de manière dépendante de la nature du support considéré: la température de post-traitement sera généralement comprise entre environ 50°C et environ 300°C, de préférence entre 70°C et 150°C environ, la durée de post-traitement étant généralement comprise entre quelques secondes et 24 heures environ.

Selon un autre aspect, la présente invention concerne aussi un support revêtu d'au moins une couche de composition polymérisée obtenue par le procédé d'irradiation décrit précédemment. Ce support peut être de nature très variée, notamment le bois, les métaux tels que l'acier et l'aluminium, les matières plastiques telles que les polyoléfines, les polycarbonates, les polyesters saturés et insaturés, les résines phénoliques et formophénohques, les polyamides, le polychlorure de vinyle, les copolymères d'éthylène et de monomères acryliques, les polyméthacrylates, etc.

Compte tenu de leur adhésion sur des supports très variés, les compositions polymérisées à base de monomères, oligomères ou polymères de formule (I) ou de formule (II) peuvent trouver de très nombreuses applications industrielles, telles que:
- revêtements minces, épais ou semi-épais sur tous les supports précités,
- adhésifs sensibles à la pression, notamment pour la fabrication de films autocollants notamment à base de polychlorure de vinyle plastifié, polyéthylène, polypropylène, polyéthylène téréphtalate ou de papier, dans cette application on préférera avoir recours à un monomère, oligomère ou polymère de formule (II) dont la séquence A₂ dérive essentiellement d un monomère acrylique,
- vernis transparents.
- mousses pour l'automobile ou films pour étiquettes en chlorure de vinyle,
- adhésifs de laminage pour laminer deux couches de matière identiques ou différentes,
- stéréolithographie, notamment pour des objets tridimensionnels,
- encres d impression notamment pour les arts graphiques.

Les exemples suivants illustrent l'invention plus en détail. Les parties et les pourcentages sont en poids, sauf indication contraire.

### Exemple 1

On prépare un polyester à terminaison carboxy en chauffant à 220°C sous atmosphère d azote et en présence de 0.2% de tris(2-éthylhexanoate)butyl étain (commercialisé par ia société M&T Chemicals Inc. sous la dénomination FASCAT 4102) un mélange de diethylene glycol et d un excès d'acide adipique en distillant 1 eau jusqu à obtenir un poids moléculaire de 1000 et un indice d'acide, mesuré selon la norme ASTM D 974-64, de 118 mg KOH/g.

Dans un réacteur on chauffe à reflux (120°C) un mélange de 262 g de 3,4-époxycyclohexylméthyl-3,4-époxycyclohexane (commercialisé par DAICEL CHEMICAL INDUSTRIES sous la dénomination CELLOXIDE 2021 P) et de 231 g de toluène, auquel on ajoute lentement, pendant une heure, un mélange de 200 g de polyester à terminaison carboxy prépare précédemment ainsi que 65 g de toluène et 0,1% d'un catalyseur commercialisé par la société AEROJET SOLID PROPULSION Company sous la dénomination AMC-2 et constitué de 5,1% de 2-éthylhexanoate de chrome dans une matrice d'esters orthophtaliques d'alcools C₇-C₁₁. L'agitation dans le réacteur est poursuivie à 120°C jusqu à ce que l'indice d'acide s'abaisse jusqu'à 4 mg KOH/g. Le mélange est alors refroidi à 80 °C et le toluène est distillé sous vide poussé.

Le produit de la réaction est ensuite analysé par chromatographie de perméation de gel en utilisant:
- instrument: pompe à haute pression MERCK HITACHI L 6000 équipée d'un injecteur automatique MERCK-HITACHI AS 2000;
- colonne: 2 x PL gel 3 µm MIXED E 300 x 7,5 mm à la température de 40°C;
- détecteur: réfractométre différentiel WATERS RI 401;
- éluent: tétrahydrofuranne stabilisé;
- débit: 1 ml/minute;
- volume injecté: 100 µl;
- traitement de données: logiciel PL calibre GPC/SEC;
- étalonnage: polystyrène standard et CELLOXIDE 2021 P.

Cette analyse permet de déterminer que le produit de la réaction est constitué de 28% de CELLOXIDE 2021 P n'ayant pas réagi et de 72% de polyester à terminaison époxycycloaliphatique selon l'invention. Par ailleurs l'équivalent époxy déterminé selon ia méthode de M. CHAKRABARTY, Analyst 95, page 85 (1970), du produit de la réaction est de 309 g.

### Exemple 2

On prépare un polyester à terminaison carboxy comme dans l'exemple 1 mais en poursuivant la réaction jusqu'à un poids moléculaire de 2000 et un indice d'acide de 57 mg KOH/g.

On procède ensuite à la réaction de ce polyester avec le diépoxyde CELLOXIDE 2021 P comme dans l'exemple précédent, à l'exception des quantités de polyester (412 g) et de toluène 338 g pour solubiliser le diépoxyde, 112 g pour solubiliser le catalyseur et le polyester).

Le produit final, analysé comme à l'exemple précédent, possède un équivalent époxy de 438 g et est constitué de 78% du polyester à terminaison époxy-cycloaliphatique selon l'invention et de 22% du CELLOXIDE 2021 P n'ayant pas réagi.

En outre le produit de la réaction est analysé par:
- spectroscopie infrarouge à transformée de Fourier au moyen d'un instrument PERKIN-ELMER 1760, les spectres étant enregistrés sous forme de films sur un cristal de bromoiodure de thallium (KRS-5) à une résolution de 4 cm⁻¹. Ces spectres sont caractérisés par des absorptions à 3512 cm⁻¹ (bande OH); 1734 cm⁻¹ (bande C=O de la fonction ester); 1255, 1176 et 1136 cm⁻¹ (bande C-O de la fonction ester).
- résonance magnétique nucléaire du proton. à une fréquence de 60 MHz, en utilisant CDCl3 comme solvant et le tétraméthylsilane comme référence. Le spectre résultant indique des déplacements chimiques de 1,63 ppm (CH₂ acide adipique et cycloaliphatiques); 2,32 ppm (CH₂ acide adipique); 3,0 ppm (époxy); 3,6 ppm (CH₂ éther); 4,15 ppm (CH₂ ester) et 4,7 ppm (CH ester).

### Exemple 3

Dans un réacteur on chauffe à 115°C un mélange de 262 g (1 mole) du 3,4-époxycyclohexylméthyl-3,4-époxycyclohexane CELLOXIDE 2021 P, 0,1% du catalyseur AMC-2 et 195 g de toluène. A cette solution on ajoute, par petites fractions pendant une heure, 30,7 g (0.21 mole) d'acide adipique. L'agitation est poursuivie à 115°C jusqu à abaisser l'indice d'acide à 1 mg KOH/g. Après refroidissement à 80°C et distillation du toluène sous vide poussé, le produit final est recueilli et analysé comme à l'exemple précédent. Il possède un équivalent époxy de 189 g, et se révèle constitué de 51% de diacide à terminaison epoxycycloaliphatique selon l'invention et de 49% du CELLOXIDE 2021 P n'ayant pas réagi.

### Exemple 4

On chauffe lentement à 50°C un mélange de 0,75 mole d'isophorone diisocyanate, 0,38 mole à acide dihydroxyméthylpropionique et de 200 ppm de trinonylphénylphosphine. Après le pic exothermique, ce mélange est agité à 75°C pendant 3 heures. Lorsque la réaction est complète on ajoute encore 0,75 mole de polypropylène glycol commercialisé par SHELL sous la dénomination PPG 1025 ainsi que 250 ppm de dilaurate de dibutylétain et l'agitation est poursuivie pendant 9 heures à 85°C, puis le polyuréthane obtenu est filtré.

Dans un réacteur, 262 g de CELLOXIDE 2021 P, 0,1% du catalyseur AMC-2 et 667 g de toluene sont chauffés à 105°C. A ce mélange on ajoute lentement, pendant une heure, une solution de 1606 g du polyuréthane obtenu précédemment (ayant un indice d'acide de 17 mg KOH/g) et de 0,1% du catalyseur dans 260 g de toluène. L'agitauon est poursuivie à 115°C jusqu à l'abaissement de l'indice d'acide à 4 mg KOH/g, puis après refroidissement à 80°C le toluène est distillé sous vide poussé. Le produit final, analysé comme à l'exemple précédent, possède un équivalent époxy de 1136 g, et est constitué de 93% de polyuréthane à terminaison époxy-cycloaliphatique selon l'invention et 7% du CELLOXIDE 2021 P n'ayant pas réagi.

### Exemple 5

On prépare tout d'abord une solution dans 666 g de toluène d'un mélange de 500 g d'acrylate de méthyle, de 500 g de méthacrylate de n-butyle, de 25 g d'acide mercaptopropionique et de 2 g d'initiateur 1,1'-azobis(2-méthylbutyronitrile).

Dans un réacteur on introduit et on chauffe à reflux le quart de cette solution puis, après le pic exothermique, on ajoute lentement les trois-quarts restants pendant 90 minutes. La solution de copolymère est alors agitée à 120°C pendant 4 heures et 2 g de l'initiateur sont ajoutés par fractions toutes les 30 minutes. Le mélange réactionnel est alors refroidi.

Dans un autre réacteur un mélange de 158 g de CELLOXIDE 2021 P et de 352 g de toluène sont chauffés à reflux. Une solution du catalyseur AMC-2 à 0,1% dans la solution de copolymère acrylique préparée précédemment est ensuite ajoutée lentement au mélange pendant 1 heure. L'agitation est poursuivie à 115°C jusqu'à ce que l'indice d'acide ait diminué jusqu à 2 mg KOH/g. Après refroidissement à 80°C et distillation du toluène sous vide poussé, puis évaporation, le produit final est recueilli puis analysé comme à l'exemple précédent. Son équivalent époxy est de 1225 g, et il se révèle constitué de 92% du polyacrylate à terminaison époxy-cycloaliphatique selon l'invention et de 8% du CELLOXIDE 2021 P n'ayant pas réagi.

### Exemple 6

On répète le processus opératoire de l'exemple 1, à l'exception de la préparation du polyester pour lequel le diéthylèneglycol est remplacé à raison de 16% par le triméthylolpropane et en poursuivant la réaction jusqu'à un poids moléculaire de 2000 et un indice d'acide de 87,4mg KOH/g.

Le produit final, analysé comme à l'exemple 1, possède un équivalent époxy de 380g et est constitué de 79% du polyester à terminaison époxy-cycloaliphatique selon l'invention et de 21% du CELLOXIDE 2021 P n'ayant pas réagi.

### Exemple 7

On prépare un polyester à terminaison carboxy comme dans l'exemple 2 mais en poursuivant la réaction jusqu'à un poids moléculaire de 3000 et un indice d'acide de 39,2mg KOH/g.

On procède ensuite à la réaction de ce polyester avec le diépoxyde CELLOXIDE 2021 P comme dans l'exemple précédent, à l'exception des quantités de polyester (627g) et de toluène (444g pour solubiliser le diépoxyde, 148g pour solubiliser le catalyseur et le polyester).

Le produit final, analysé comme à l'exemple 1, possède un équivalent époxy de 568g et est constitué de 83% du polyester à terminaison époxy-cycloaliphatique selon l'invention et de 17% du CELLOXIDE 2021 P n'ayant pas réagi.

### Exemple 8

On répète le processus opératoire de l'exemple 2, à l'exception du remplacement total du diéthyléneglycol par une quantité molaire équivalente de butanediol et en poursuivant la réaction jusqu'à un poids moléculaire de 2000 et un indice d'acide de 70,1mg KOH/g.

Le produit final, analysé comme à l'exemple 1, possède un équivalent époxy de 405g et est constitué de 78% du polyester à terminaison époxy-cycloaliphatique selon l'invention et de 22% du CELLOXIDE 2021 P n'ayant pas réagi.

### Exemple 9

On répète le processus opératoire de l'exemple 3. à l'exception du remplacement total de l'acide adipique par une quantité molaire équivalente d acide azélaïque.

Le produit final, analysé comme à l'exemple 1, possède un équivalent époxy de 198g et est constitue de 54% du diacide à terminaison époxy-cycloaliphatique selon l'invention et de 46% du CELLOXIDE 2021 P n'ayant pas réagi.

### Exemple 10

On répète le processus opératoire de l'exemple 3, à l'exception du remplacement total de l'acide adipique par une quantité molaire équivalente d'acide décanedicarboxylique.

Le produit final. analysé comme à l'exemple 1, possède un équivalent époxy de 201g et est constitué de 54% du diacide à terminaison époxy-cycloaliphatique selon l'invention et de 46% du CELLOXIDE 2021 P n'ayant pas réagi.

### Exemple 11

On repète le processus opératoire de l'exemple 3, à l'exception du remplacement total de l'acide adipique par une quantité molaire équivalente d'acide succinique.

Le produit final, analysé comme à l'exemple 1, possède un équivalent époxy de 187g et est constitue de 52% du polyester à terminaison époxy-cycloaliphatique selon l'invention et de 48% du CELLOXIDE 2021 P n'ayant pas réagi.

### Exemple 12

On répète le processus opératoire de l'exemple 3, à l'exception du remplacement total de l'acide adipique par une quantité molaire équivalente d'acide laurique.

Le produit final, analysé comme à l'exemple 1, possède un équivalent époxy de 232g et est constitué de 63% du monoacide à terminaison époxy-cycloaliphatique selon l'invention et de 37% du CELLOXIDE 2021 P n'ayant pas réagi.

### Exemple 13

On répète le processus opératoire de l'exemple 3, à l'exception du remplacement total de l'acide adipique par une quantité molaire équivalente d'acide téréphtalique.

Le produit final, analysé comme à l'exemple 1, possède un équivalent époxy de 196g et est constitué de 55% du diacide à terminaison époxy-cycloaliphatique selon l'invention et de 45% du CELLOXIDE 2021 P n'ayant pas réagi.

### Exemple 14

On répète le processus opératoire de l'exemple 5, aux deux exceptions suivantes près:
- dans la première étape l'initiateur utilisé est le 4,4'-azobis(acide 4-cyanovalérique) commercialisé pour la société WAKO PURE CHEMICAL INDUSTRIES sous le nom Vazo 501.
- dans la dernière étape (autre réacteur), on met en oeuvre 185 g de CELLOXIDE 2021 P et 388 g de toluène.

Le produit final, analysé comme à l'exemple 1, possède un équivalent époxy de 1067 g et se révèle constitué de 91% du polyacrylate à terminaison époxy-cycloaliphatique selon l'invention et de 9% du CELLOXIDE 2021 P n'ayant pas réagi.

### Exemple 15

Dans un réacteur on chauffe à 115°C un mélange de 262 g de CELLOXIDE 2021 P, 292 g (2 moles) d'acide adipique, 0.1% de catalyseur AMC-2 et 892 g de toluène. L'agitation est poursuivie jusqu à abaisser l'indice d'acide jusqu'à 78 mg KOH/g. Puis on ajoute en une fois 786 g (3 moles) de CELLOXIDE 2021 P et l'agitation est poursuivie jusqu'à abaisser l'indice d acide jusqu'à 1 mg KOH/g. Après refroidissement à 80°C et distillation du toluène sous vide poussé, le produit final est recueilli et analysé comme aux exemples précédents. Il possède un équivalent époxy de 341 g et se révèle constitué de 80% de diacide à terminaison époxy-cycloaliphatique selon l'invention et de 20% du CELLOXIDE 2021 P n'ayant pas réagi.

### Exemple 16

Diverses propriétés de formulations réticulées à partir de produits obtenus aux exemples précédents ont été testées sur des films d'épaisseur 10 µm préparés manuellement au moyen d'un filmographe à spirale sur divers substrats.

Chaque formulation testée comprend 70 parties de CELLOXIDE 2021 P, 30 parties du produit à terminaison époxycycloaliphatique (selon l'invention) d'un exemple précédent et 3 parties en poids d'un photoinitiateur cationique commercialisé par la société MINNESOTA MINING AND MANUFACTURING sous le nom FX-512 et constitué à 60% d'hexafluorophosphate de triphénylsulfonium et à 40% de γ-butyrolactone.

Les propriétés déterminées sont les suivantes:
- réactivités de la formulation mesurées par sa vitesse de réticulation VR (exprimée en mètres par minute et définie comme la vitesse de défilement sous une lampe à rayonnement ultraviolet de puissance 80 W/cm autorisant l'obtention d'un film sec au doigt (évaluation au toucher par un opérateur) et la vitesse à laquelle des particules de talc n'adhèrent plus à la surface du revètement VT (exprimée en mètres par minute).
- résistances aux solvants mesurées après 24 heures par la résistance à l'acétone RA (exprimée en nombre de doubles frictions par l'acétone administrée au film jusqu'à son décollement du support).
- dureté Kônig DK après 24 heures environ, exprimée en secondes et déterminée selon la norme ASTM D 4366.
- adhésion à 23°C, exprimée en % et déterminée par l'essai d'adhérence selon la norme ASTM D-3002 pour divers substrats: ALU (aluminium), PET (polyester), PVC (polychlorure de vinyle), verre, PE (polyéthylène) et PP (polypropylène).

Le résultats de ces diverses mesures sont rassemblées dans le tableau ci-après.

**TABLEAU**

| Produit de l'exemple | VR | VT | RA | DK | Adhésion | | | | | |
|---|---|---|---|---|---|---|---|---|---|---|
| | | | | | ALU | PET | PVC | PE | PP | Verre |
| 1 | > 100 | > 100 | 60 | 205 | 0 | 0 | 100 | 80 | nd | nd |
| 2 | > 100 | > 100 | > 100 | 160 | 0 | 0 | 100 | 100 | 100 | nd |
| 3 | > 100 | > 100 | 20 | 226 | 100 | 100 | 100 | 90 | 100 | 100 |
| 5 | 30 | 20 | > 100 | 191 | 100 | 0 | 100 | 100 | nd | nd |
| 6 | 80 | 75 | > 100 | 185 | 100 | 100 | 100 | 50 | 100 | 100 |
| 7 | 80 | 70 | 65 | 175 | 100 | 100 | 100 | 100 | 90 | 100 |
| 8 | 60 | 55 | > 100 | 180 | 0 | 100 | 100 | 100 | 100 | nd |
| 9 | 70 | 60 | 25 | 243 | 100 | 100 | 100 | 100 | 100 | 100 |
| 10 | 60 | 50 | 10 | 224 | 100 | 100 | 100 | 100 | 100 | 100 |
| 11 | > 100 | > 100 | 50 | 226 | 100 | 100 | 100 | 100 | 100 | 100 |
| 12 | 40 | 30 | 75 | 165 | 100 | 100 | 100 | 100 | 100 | 100 |
| 13 | 45 | 40 | 9 | 187 | 100 | 100 | 100 | 100 | 50 | 100 |
| 15 | 50 | 40 | >100 | nd | 100 | 100 | 100 | 100 | 100 | nd |
| CELLOXIDE pur | > 100 | 100 | 5 | 203 | 100 | 0 | 100 | 80 | 100 | 100 |
| nd = non déterminé | | | | | | | | | | |

Dans ce tableau figurent également, à titre comparatif, les résultats des mesures correspondantes effectuées sur le produit CELLOXIDE 2021 P de départ. Ces résultats montrent, pour des compositions réticulées ne comprenant que 30% en poids du polymère à terminaison époxycycloaliphatique selon l'invention, une amélioration très importante de la résistance aux solvants (RA) qui est obtenue tout en maintenant une vitesse de réticulation satisfaisante et tout en maintenant ou améliorant l'adhésion sur divers substrats.

## Revendications

1. Monomères, oligomères et polymères choisis parmi ceux de formule générale(I): 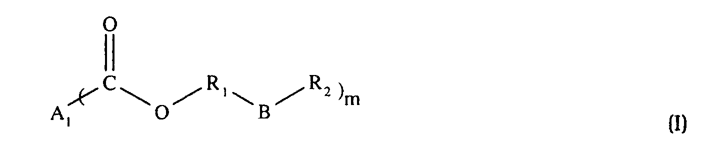 dans laquelle:
- A₁ est choisi parmi les séquences polyesters ayant un poids moléculaire compris entre 250 et 10000, les séquences polyuréthannes ayant un poids moléculaire compris entre 500 et 5000, et les squelettes hydrocarbonés d'un acide mono- ou polycarboxylique, et les produits d'addition d'un acide polycarboxylique et d'un diépoxyde cycloaliphatique,
- m est un nombre de 1 à 6,
- R₁ est un groupe cycloaliphatique porteur d'un groupe hydroxyle situé en β de l'atome d'oxygène auquel est lié R, et le cas échéant porteur de substituant(s),
- R₂ est un second groupe cycloaliphatique porteur d'un groupe oxiranne situé en extrémité de chaîne et le cas échéant porteur de substituant(s), et
- B est choisi parmi une ou plusieurs liaisons covalentes, un atome d'oxygène et des radicaux hydrocarbonés linéaires, ramifiés ou cycliques porteurs le cas échéant d'atomes d'oxygène et/ou de silicium,
et ceux de formule générale (II): 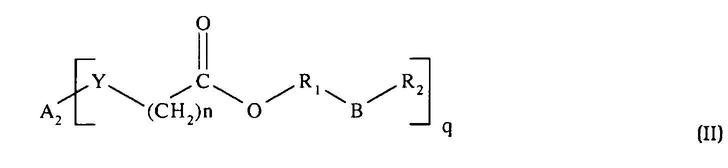 dans laquelle:
- A₂ est une séquence choisie parmi les homopolymères et copolymères d'au moins un monomère vinylique,
- n est un nombre entier de 0 à 15, avec la condition que n est au moins égal à 1 lorsque Y est le soufre, et
- Y est choisi parmi l'atome de soufre, les radicaux -CR'R" dans lesquels R' et R" sont chacun un groupe aliphatique ayant de 1 à 4 atomes de carbone, et leur mélanges,
- q est un nombre, entier ou non, allant de 1 à 2,
- R₁, B et R₂ sont définis comme dans la formule (I) ci-dessus.

2. Monomères, oligomères et polymères selon la revendication 1, **caractérisés en ce que** R₁ et R₂ sont des groupes cycloaliphatiques dont le cycle possède de 5 à 6 chaînons et pouvant porter un ou plusieurs substituants hydrocarbonés peu encombrés stériquement.

3. Monomères, oligomères et polymères selon l'une des revendications 1 et 2, **caractérisés en ce que** B est un radical choisi parmi:
- des groupes alkylènes -(CH₂)n- dans lesquels n est un nombre entier de 1 à 12,
- un groupe -CH=CH-
- un groupe de formule 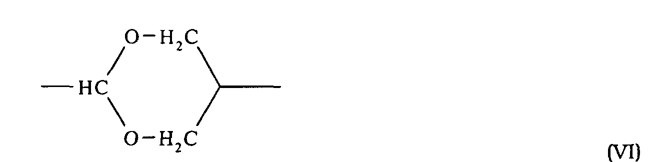 ou 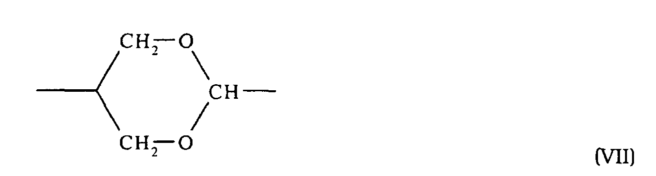
- un groupe de formule 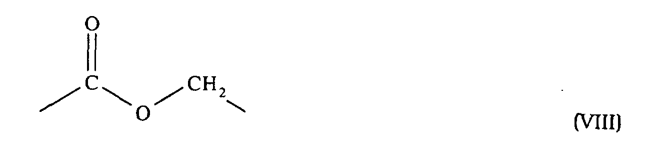 ou 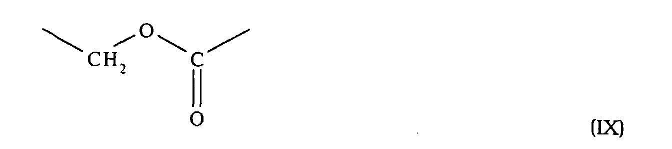
- un groupe de formule (X) 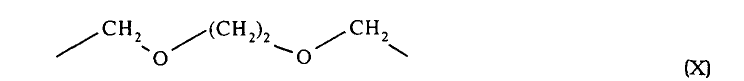
- un groupe de formule (XI) 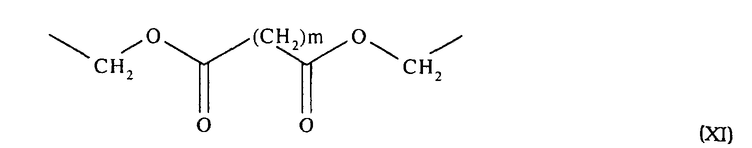 dans laquelle m est un nombre entier de 0 à 20, de préférence de 1 à 6,
- un groupe de formule (XII) 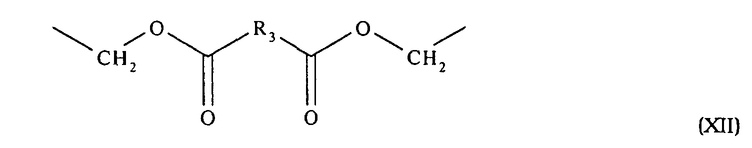 dans laquelle R₃ est un radical cycloaliphatique pouvant le cas échéant porter un groupe oxiranne 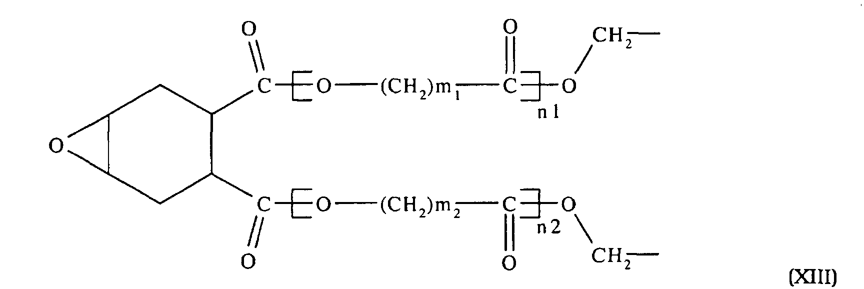 dans laquelle m₁ et m₂ sont chacun un nombre entier de 1 à 6, et n₁ et n₂ sont chacun un nombre entier de 0 à 2
- un groupe de formule (XIV) 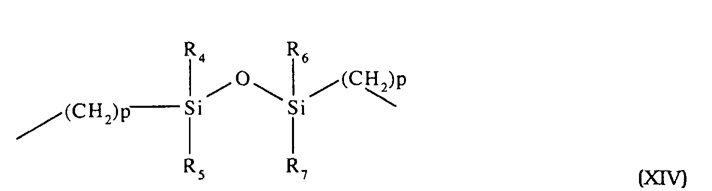 dans laquelle p est un nombre entier de 1 à 10, de préférence de 1 à 3, R₄, R₅, R₆ et R₇ sont chacun choisis indépendamment parmi les radicaux alkyles ayant de 1 à 4 atomes de carbone, de préférence le radical méthyle,
- un groupe de formule (XV) 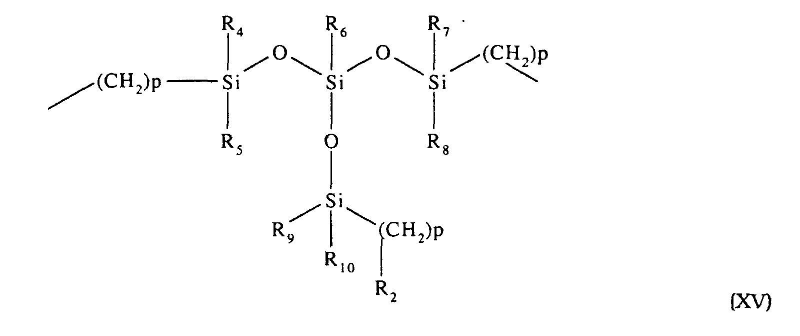 dans laquelle p est un nombre entier de 1 à 10, de préférence 1 à 3, R₄, R₅, R₇, R₈, R₉ et R₁₀ sont chacun choisis indépendamment, parmi les radicaux alkyles ayant de 1 à 4 atomes de carbone, de préférence le radical méthyle, et R₆ est choisi parmi les radicaux alkyles ayant de 1 à 4 atomes de carbone, de préférence le radical méthyle, et les radicaux aryles ayant de 6 à 9 atomes de carbone, de préférence le radical phényle, et R₂ a la même signification que dans la formule (I) ci-dessus,
- un groupe de formule (XVI) 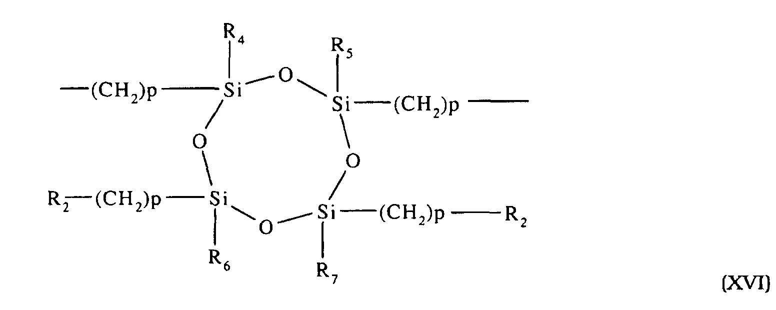 dans laquelle R₄, R₅, R₆ et R₇ sont chacun choisis indépendamment, parmi les radicaux alkyles ayant de 1 à 4 atomes de carbone, de préférence le radical méthyle, p est un nombre entier de 1 à 20, de préférence 1 à 6, et R₂ a la même signification que dans la formule (I) ci-dessus,

4. Monomères, oligomères ou polymères selon l'une des revendications 1 à 3, **caractérisés en ce que** A₁ est le squelette hydrocarboné d'un acide choisi parmi les monoacides aliphatiques saturés, les diacides aliphatiques saturés ou insaturés ayant de 4 à 40 atomes de carbone, les diacides aromatiques et les triacides carboxyliques.

5. Monomères, oligomères ou polymères selon l'une des revendications 1 à 3, **caractérisés en ce que** le monomère vinylique de la séquence A₂ est choisi parmi les esters acryliques ou méthacryliques et parmi les monomères vinylaromatiques copolymérisables avec lesdits esters.

6. Procédé de préparation de monomères, oligomères et polymères selon la revendication 1, **caractérisé en ce qu'**il comprend la réaction d'un composé monomère ou polymère de formule générale (XVII) 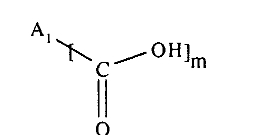 dans laquelle A₁ et m sont comme définis dans la formule (I) (en vue de l'obtention des composés de formule I) ou bien de formule générale (XVIII) 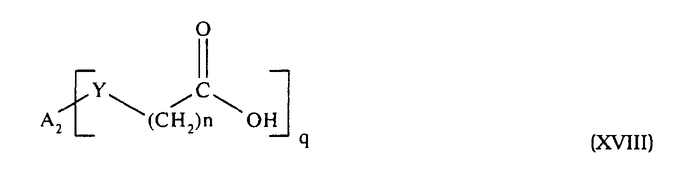 dans laquelle A₂, Y, q et n sont comme définis dans la formule (II) (en vue de l'obtention des composés de formule II) avec un diépoxyde cycloaliphatique de formule générale (XIX) 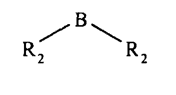 dans laquelle B et R₂ sont comme définis dans les formules (I) et (II), le rapport molaire du diépoxyde (XIX) au monomère ou polymère de formule (XVII) ou (XVIII) étant tel qu'au moins une fonction époxyde du composé (XIX) reste disponible pour une autre réaction ultérieure éventuelle.

7. Procédé de préparation selon la revendication 6, **caractérisé en ce qu'**on utilise au moins deux équivalents d'époxy pour un équivalent d'acide carboxylique.

8. Procédé de préparation selon l'une des revendications 6 et 7, **caractérisé en ce que** la réaction est effectuée en présence d'au moins un solvant.

9. Procédé de préparation selon l'une des revendications 6 à 8, **caractérisé en ce que** la réaction est effectuée à une température allant de 100°C à 150°C.

10. Procédé de préparation selon l'une des revendications 6 à 9, **caractérisé en ce que** la réaction est effectuée en présence d'une quantité catalytique d'un composé connu pour promouvoir la réaction entre la fonction époxyde et la fonction acide carboxylique.

11. Procédé de préparation selon la revendication 10, **caractérisé en ce que** ledit composé est choisi parmi le chlorure et les tricarboxylates de chrome trivalent, les halogénures d'ammonium quaternaires et le chlorure ferrique.

12. Procédé de préparation selon l'une des revendications 10 et 11, **caractérisé en ce que** ledit composé est employé dans une proportion allant jusqu'à 0,2% en poids par rapport à la somme du monomère ou polymère de formule (XVII) ou (XVIII) et du diépoxyde cycloaliphatique de formule (XIX).

13. Procédé de polymérisation sous irradiation d'une composition comprenant au moins un monomère, oligomère ou polymère de formule (I) ou (II) selon la revendication 1 en présence d'au moins un photoinitiateur de polymérisation cationique et le cas échéant en présence d'un autre composé cationiquement polymérisable en présence de ce photoinitiateur.

14. Procédé de polymérisation sous irradiation selon la revendication 13, **caractérisé en ce que** ledit photoinitiateur de polymérisation cationique est choisi parmi les sels de diazonium aromatiques et d'halogénures complexes, les sels complexes d'iodonium aromatique, les sels complexes de sulfonium aromatiques, les sels d'onium du groupe VIa et les sels complexes aromatiques de métaux de transition.

15. Procédé de polymérisation sous irradiation selon l'une des revendications 13 et 14, **caractérisé en ce que** l'autre composé cationiquement polymérisable est choisi parmi les monoépoxydes cycloaliphatiques et non cycloaliphatiques mono- ou multifonctionnels, les diépoxydes aliphatiques, les polyglycidyléthers de phénols polyhydriques, les résines amino-glycidylées aromatiques et hétérocycliques, les résines dérivées du triglycidyl-p-aminophénol, les résines à base de triazines, les résines époxy-hydantoïne, les adducts d'époxy-alcools alicycliques et d'isocyanates (méth)acryliques, les dérivés époxydés de composés naturels insaturés et de polymères synthétiques insaturés, les vinyléthers aliphatiques et cycliques, les alkylvinyléthers, les propényléthers et les oxétanes.

16. Procédé de polymérisation sous irradiation selon l'une des revendications 13 à 15, **caractérisé en ce que** lorsqu'un autre composé cationiquement polymérisable est présent, il constitue au plus 50% en poids de la composition à polymériser.

17. Procédé de polymérisation sous irradiation selon l'une des revendications 13 à 16, **caractérisé en ce que** le photoinitiateur cationique est présent à raison de 0,1% à 10% en poids de la matière organique polymérisable.

18. Procédé de polymérisation sous irradiation selon l'une des revendications 13 à 17, **caractérisé en ce qu'**il est mis en oeuvre au moyen de rayonnement ultraviolet.

19. Procédé de polymérisation sous irradiation selon la revendication 18, **caractérisé en ce que** la composition comprend en outre un photoinitiateur autre que le photoinitiateur cationique.

20. Procédé de polymérisation sous irradiation selon l'une des revendications 13 à 19, **caractérisé en ce que** la composition comprend en outre au moins un additif choisi parmi les photoactivateurs, les agents mouillants ou modificateurs de surface, les promoteurs d'adhésion, les charges minérales ou organiques, les pigments minéraux, les colorants organiques, les agents antistatiques, les anti-mousses et les agents épaississants.

21. Procédé de polymérisation sous irradiation selon l'une des revendications 13 à 17, **caractérisé en ce que** l'irradiation est effectuée au moyen d'un accélérateur d'électrons.

## Patentansprüche

1. Monomere, Oligomere und Polymere, ausgewählt unter denjenigen der allgemeinen Formel (I): 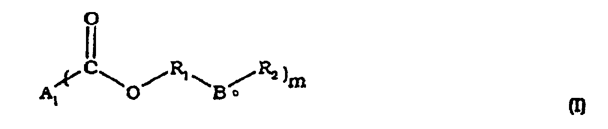 worin:
- A₁ unter Polyesterblöcken mit einem Molekulargewicht zwischen 250 und 10.000, Polyurethanblöcken mit einem Molekulargewicht zwischen 500 und 5000 und Kohlenwasserstoffgerüsten einer Mono- oder Polycarbonsäure und Additionsprodukten aus einer Polycarbonsäure und einem cycloaliphatischen Diepoxid ausgewählt ist,
- m für eine Zahl von 1 bis 6 steht,
- R₁ für eine cycloaliphatische Gruppe mit einer in β-Stellung zu dem Sauerstoffatom, an das R₁ gebunden ist, stehenden Hydroxylgruppe und gegebenenfalls einem oder mehreren Substituenten steht,
- R₂ für eine zweite cycloaliphatische Gruppe mit einer am Kettenende stehenden Oxirangruppe und gegebenenfalls einem oder mehreren Substituenten steht,
- B unter einer oder mehreren kovalenten Bindungen, einem Sauerstoffatom und linearen, verzweigten oder cyclischen Kohlenwasserstoffresten, die gegebenenfalls Sauerstoff- und/oder Siliciumatome tragen, ausgewählt ist,
und denjenigen der allgemeinen Formel (II): 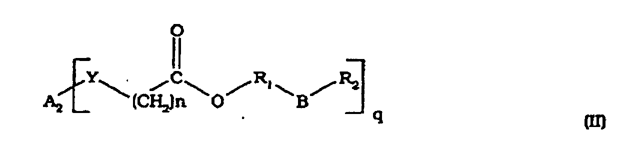 worin:
- A₂ für einen unter Homopolymeren und Copolymeren mindestens eines Vinylmonomers ausgewählten Block steht,
- n für eine ganze Zahl von 0 bis 15 steht, mit der Maßgabe, daß n mindestens gleich 1 ist, wenn Y für Schwefel steht,
- Y unter einem Schwefelatom, -CR'R"-Resten, worin R' und R" jeweils für eine aliphatische Gruppe mit 1 bis 4 Kohlenstoffatomen stehen, und Gemischen davon ausgewählt ist,
- q für eine ganze oder gebrochene Zahl von 1 bis 2 steht und
- R₁, B und R₂ die gleiche Bedeutung wie in obiger Formel (I) besitzen.

2. Monomere, Oligomere und Polymere nach Anspruch 1, **dadurch gekennzeichnet, daß** R₁ und R₂ für cycloaliphatische Gruppen, die einen 5- bis 6-gliedrigen Ring aufweisen und einen oder mehrere, sterisch wenig gehinderte Kohlenwasserstoffsubstituenten tragen können, stehen.

3. Monomere, Oligomere und Polymere nach Anspruch 1 oder 2, **dadurch gekennzeichnet, daß** B für einen unter:
- Alkylengruppen -(CH₂)ₙ-, worin n für eine Zahl von 1 bis 12 steht,
- einer Gruppe -CH=CH-
- einer Gruppe der Formel 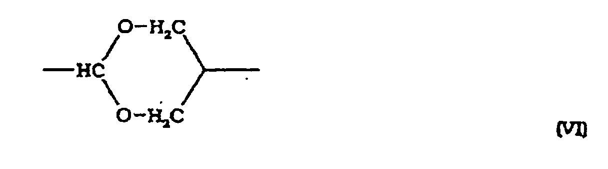 oder 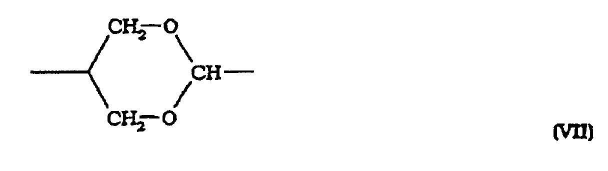
- einer Gruppe der Formel 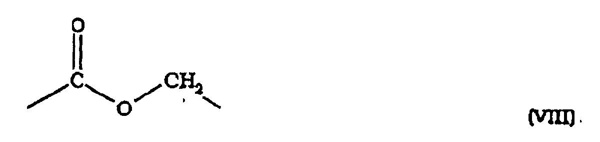 oder 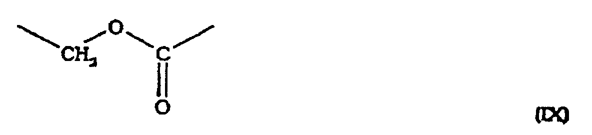
- einer Gruppe der Formel (X) 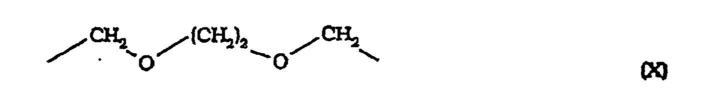
- einer Gruppe der Formel (XI) 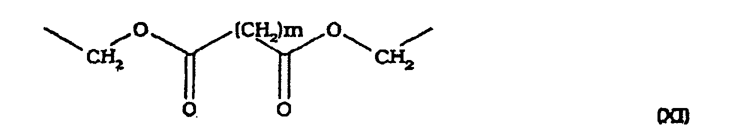 worin m für eine ganze Zahl von 0 bis 20 und vorzugsweise 1 bis 6 steht,
- einer Gruppe der Formel (XII) 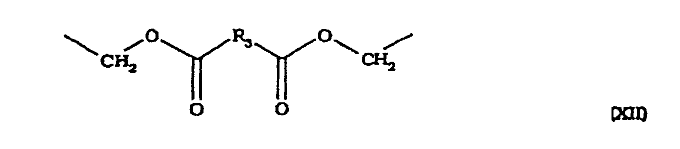 worin R₃ für einen cycloaliphatischen Rest, der gegebenenfalls eine Oxirangruppe 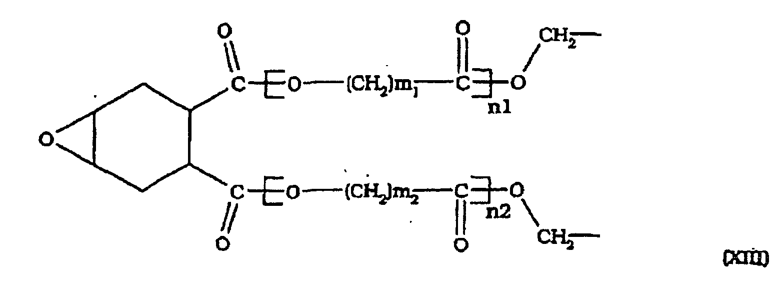 worin m₁ und m₂ jeweils für eine ganze Zahl von 1 bis 6 stehen und n₁ und n₂ jeweils für eine ganze Zahl von 0 bis 2 stehen, tragen kann, steht,
- einer Gruppe der Formel (XIV) 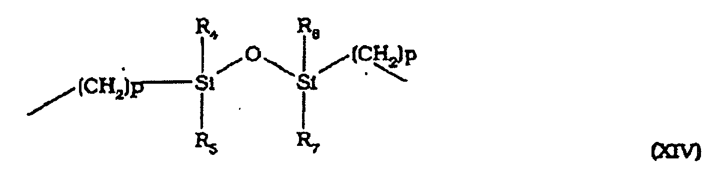 worin p für eine ganze Zahl von 1 bis 10 und vorzugsweise 1 bis 3 steht und R₄, R₅, R₆ und R₇ jeweils unabhängig voneinander unter Alkylresten mit 1 bis 4 Kohlenstoffatomen, vorzugsweise dem Methylrest, ausgewählt sind,
- einer Gruppe der Formel (XV) 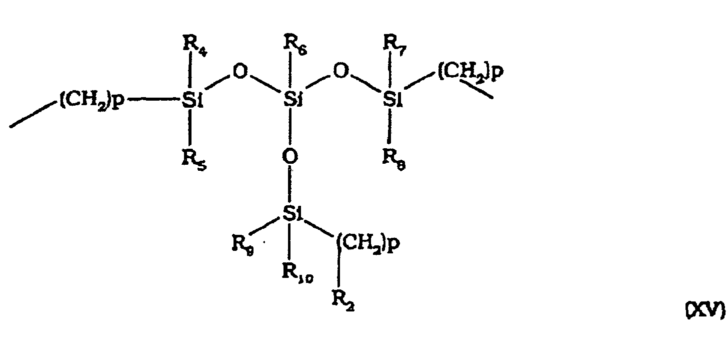 worin p für eine ganze Zahl von 1 bis 10 und vorzugsweise 1 bis 3 steht, R₄, R₅, R₇, R₈, R₉ und R₁₀ jeweils unabhängig voneinander unter Alkylresten mit 1 bis 4 Kohlenstoffatomen, vorzugsweise dem Methylrest, ausgewählt sind, R₆ unter Alkylresten mit 1 bis 4 Kohlenstoffatomen, vorzugsweise dem Methylrest, und Arylresten mit 6 bis 9 Kohlenstoffatomen, vorzugsweise dem Phenylrest, ausgewählt ist und R₂ die gleiche Bedeutung wie in obiger Formel (I) besitzt,
- einer Gruppe der Formel (XVI) 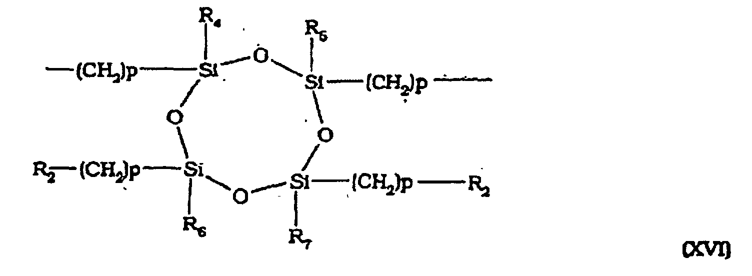 worin R₄, R₅, R₆ und R₇ jeweils unabhängig voneinander unter Alkylresten mit 1 bis 4 Kohlenstoffatomen, vorzugsweise dem Methylrest, ausgewählt sind, p für eine ganze Zahl von 1 bis 20 und vorzugsweise 1 bis 6 steht und R₂ die gleiche Bedeutung wie in obiger Formel (I) besitzt,
ausgewählten Rest steht.

4. Monomere, Oligomere bzw. Polymere nach einem der Ansprüche 1 bis 3, **dadurch gekennzeichnet, daß** A₁ für das Kohlenwasserstoffgerüst einer unter gesättigten aliphatischen einwertigen Säuren, gesättigten oder ungesättigten aliphatischen zweiwertigen Säuren mit 4 bis 40 Kohlenstoffatomen, aromatischen zweiwertigen Säuren und Tricarbonsäuren ausgewählten Säure steht.

5. Monomere, Oligomere bzw. Polymere nach einem der Ansprüche 1 bis 3, **dadurch gekennzeichnet, daß** das Vinylmonomer des Blocks A₂ unter Acryl- oder Methacrylsäureestern und mit diesen Estern copolymerisierbaren vinylaromatischen Monomeren ausgewählt ist.

6. Verfahren zur Herstellung von Monomeren, Oligomeren und Polymeren gemäß Anspruch 1, **dadurch gekennzeichnet, daß** man (zur Herstellung der Verbindungen der Formel I) eine monomere oder polymere Verbindung der allgemeinen Formel (XVII) 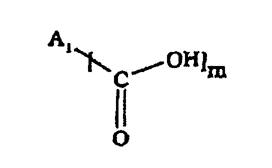 worin A₁ und m die gleiche Bedeutung wie in Formel (I) besitzen, oder auch (zur Herstellung der Verbindungen der Formel II) der allgemeinen Formel (XVIII) 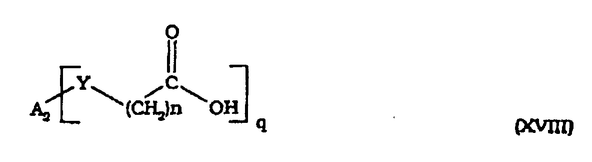 worin A₂, Y, q und n die gleiche Bedeutung wie in Formel (II) besitzen, mit einem cycloaliphatischen Diepoxid der allgemeinen Formel (XIX) 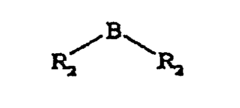 worin B und R₂ die gleiche Bedeutung wie in den Formeln (I) und (II) besitzen, umsetzt, wobei das Molverhältnis von Diepoxid (XIX) zu Monomer bzw. Polymer der Formel (XVII) bzw. (XVIII) so gewählt wird, daß mindestens eine Epoxidfunktion der Verbindung (XIX) für eine eventuelle nachfolgende andere Reaktion verfügbar bleibt.

7. Verfahren nach Anspruch 6, **dadurch gekennzeichnet, daß** man pro Äquivalent Carbonsäure mindestens zwei Äquivalente Epoxid verwendet.

8. Verfahren nach Anspruch 6 oder 7, **dadurch gekennzeichnet, daß** man die Umsetzung in Gegenwart mindestens eines Lösungsmittels durchführt.

9. Verfahren nach einem der Ansprüche 6 bis 8, **dadurch gekennzeichnet, daß** man die Umsetzung bei einer Temperatur von 100°C bis 150°C durchführt.

10. Verfahren nach einem der Ansprüche 6 bis 9, **dadurch gekennzeichnet, daß** man die Umsetzung in Gegenwart einer katalytisch wirksamen Menge einer Verbindung, die bekanntlich die Reaktion zwischen der Epoxidfunktion und der Carbonsäurefunktion fördert, durchführt.

11. Verfahren nach Anspruch 10, bei dem man die Verbindung unter Chrom(III)-chlorid und Chrom(III)-tricarboxylaten, quaternären Ammoniumhalogeniden und Eisen(III)-chlorid auswählt.

12. Verfahren nach Anspruch 10 oder 11, **dadurch gekennzeichnet, daß** man die Verbindung in einem Anteil von bis zu 0,2 Gew.-%, bezogen auf die Summe des Monomers bzw. Polymers der Formel (XVII) bzw. (XVIII) und des cycloaliphatischen Epoxids der Formel (XIX), einsetzt.

13. Verfahren zur Polymerisation einer Zusammensetzung mit mindestens einem Monomer, Oligomer bzw. Polymer der Formel (I) oder (II) gemäß Anspruch 1 unter Bestrahlung in Gegenwart mindestens eines Photoinitiators für die kationische Polymerisation und gegebenenfalls in Gegenwart einer anderen, in Gegenwart dieses Photoinitiators kationisch polymerisierbaren Verbindung.

14. Verfahren zur Polymerisation unter Bestrahlung nach Anspruch 13, **dadurch gekennzeichnet, daß** man den Photoinitiator für die kationische Polymerisation unter Salzen von aromatischen Diazoniumkationen und komplexen Halogeniden, aromatenhaltigen Iodoniumkomplexsalzen, aromatenhaltigen Sulfoniumkomplexsalzen, Oniumsalzen der Gruppe VIa und aromatenhaltigen Übergangsmetallkomplexsalzen auswählt.

15. Verfahren zur Polymerisation unter Bestrahlung nach Anspruch 13 oder 14, **dadurch gekennzeichnet, daß** man die andere kationisch polymerisierbare Verbindung unter mono- oder multifunktionellen, cycloaliphatischen und nicht cycloaliphatischen Monoepoxiden, aliphatischen Diepoxiden, Polyglycidylethern mehrwertiger Phenole, aromatischen und heterocyclischen Aminoglycidylharzen, von Triglycidyl-p-aminophenol abgeleiteten Harzen, auf Triazin basierenden Harzen, Epoxyhydantoinharzen, Addukten aus alicyclischen Epoxyalkoholen und (Meth)acryloylisocyanaten, Epoxidderivaten ungesättigter natürlicher Verbindungen und ungesättigter synthetischer Polymere, aliphatischen und cyclischen Vinylethern, Alkylvinylethern Propenylethern und Oxetanen auswählt.

16. Verfahren zur Polymerisation unter Bestrahlung nach einem der Ansprüche 13 bis 15, **dadurch gekennzeichnet, daß** eine andere kationisch polymerisierbare Verbindung, wenn sie vorhanden ist, höchstens 50 Gew.-% der zu polymerisierenden Zusammensetzung ausmacht.

17. Verfahren zur Polymerisation unter Bestrahlung nach einem der Ansprüche 13 bis 16, **dadurch gekennzeichnet, daß** der kationische Photoinitiator in einem Anteil von 0,1 bis 10 Gew.-%, bezogen auf die polymerisierbare organische Substanz, vorliegt.

18. Verfahren zur Polymerisation unter Bestrahlung nach einem der Ansprüche 13 bis 17, **dadurch gekennzeichnet, daß** es mittels UV-Strahlung durchgeführt wird.

19. Verfahren zur Polymerisation unter Bestrahlung nach Anspruch 18, **dadurch gekennzeichnet, daß** die Zusammensetzung außerdem auch noch einen anderen Photoinitiator als den kationischen Photoinitiator enthält.

20. Verfahren zur Polymerisation unter Bestrahlung nach einem der Ansprüche 13 bis 19, **dadurch gekennzeichnet, daß** die Zusammensetzung außerdem auch noch ein unter Photoaktivatoren, Netzmitteln oder Oberflächenmodifizierungsmitteln, anorganischen oder organischen Füllstoffen, anorganischen Pigmenten, organischen Farbmitteln, Antistatika, Antischaummitteln und Verdickungsmitteln ausgewähltes Additiv enthält.

21. Verfahren zur Polymerisation unter Bestrahlung nach einem der Ansprüche 13 bis 17, **dadurch gekennzeichnet, daß** man die Bestrahlung mit Hilfe eines Elektronenbeschleunigers durchführt.

## Claims

1. Monomers, oligomers and polymers chosen from those of general formula (I): 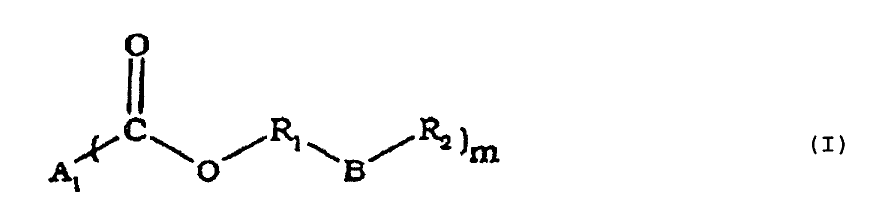 in which:
- A₁ is chosen from polyester blocks having a molecular weight of between 250 and 10,000, polyurethane blocks having a molecular weight of between 500 and 5000, hydrocarbon-comprising backbones of a mono- or polycarboxylic acid and addition products of a polycarboxylic acid and of a cycloaliphatic diepoxide,
- m is a number from 1 to 6,
- R₁ is a cycloaliphatic group carrying a hydroxyl group situated in the β position with respect to the oxygen atom to which R₁ is bonded which, if appropriate, carries substituent(s),
- R₂ is a second cycloaliphatic group carrying an oxirane group situated at the chain end which, if appropriate, carries substituent(s), and
- B is chosen from one or more covalent bonds, an oxygen atom and linear, branched or cyclic hydrocarbon-comprising radicals carrying, if appropriate, oxygen and/or silicon atoms,
and those of general formula (II): 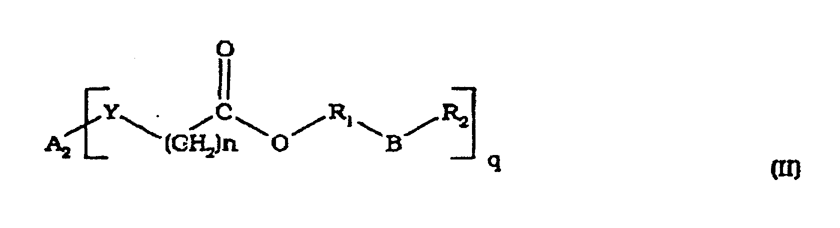 in which:
- A₂ is a block chosen from homopolymers and copolymers of at least one vinyl monomer,
- n is an integer from 0 to 15, with the condition that n is at least equal to 1 when Y is sulphur, and
- Y is chosen from a sulphur atom, -CR'R" radicals, in which R' and R" are each an aliphatic group having from 1 to 4 carbon atoms, and their mixtures,
- q is an integer or non-integer ranging from 1 to 2,
- R₁, B and R₂ are defined as in the above formula (I).

2. Monomers, oligomers and polymers according to Claim 1, **characterized in that** R₁ and R₂ are cycloaliphatic groups with a ring having from 5 to 6 members which can carry one or more hydrocarbon-comprising substituents which are not very sterically hindered.

3. Monomers, oligomers and polymers according to either of Claims 1 and 2, **characterized in that** B is a radical chosen from:
- -(CH₂)ₙ- alkylene groups in which n is an integer from 1 to 12,
- a -CH=CH- group
- a group of formula 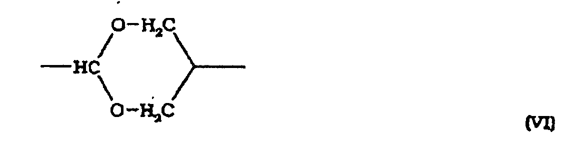 or 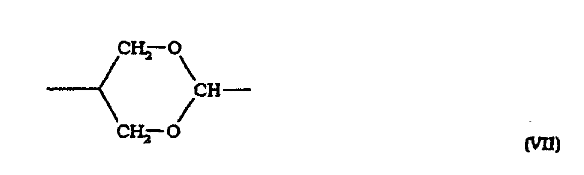
- a group of formula 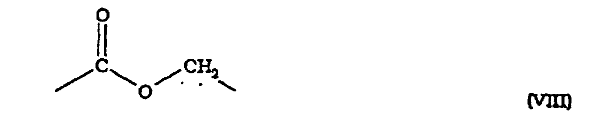 or 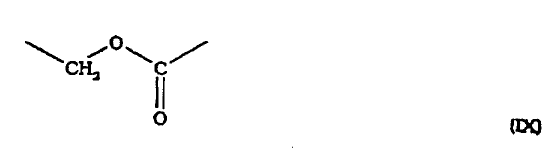
- a group of formula (X) 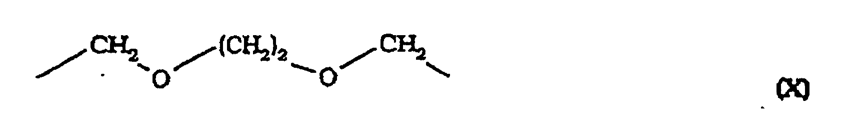
- a group of formula (XI) 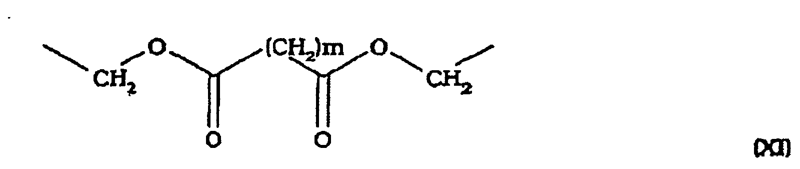 in which m is an integer from 0 to 20, preferably from 1 to 6,
- a group of formula (XII) 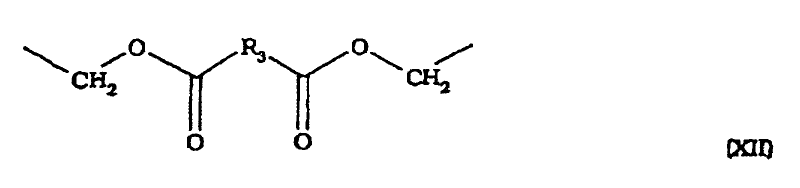 in which R₃ is a cycloaliphatic radical, which can, if appropriate, carry an oxirane group 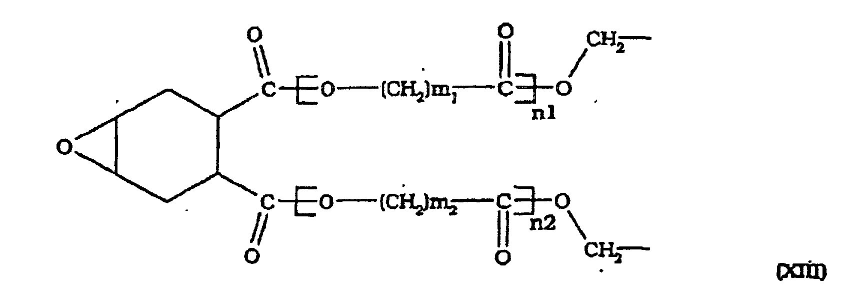 in which m₁ and m₂ are each an integer from 1 to 6 and n₁ and n₂ are each an integer from 0 to 2
- a group of formula (XIV) 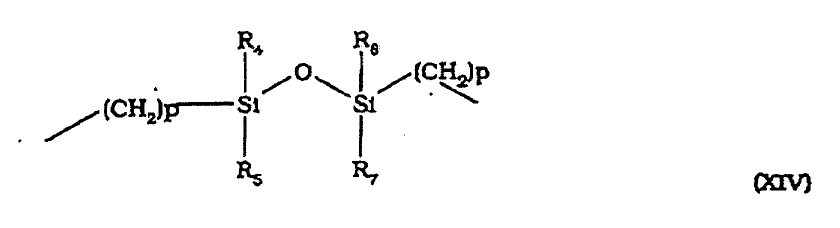 in which p is an integer from 1 to 10, preferably from 1 to 3, and R₄, R₅, R₆ and R₇ are each chosen independently from alkyl radicals having from 1 to 4 carbon atoms, preferably the methyl radical,
- a group of formula (XV) 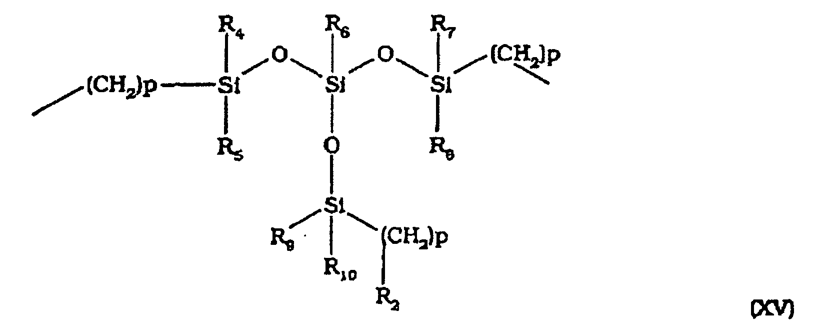 in which p is an integer from 1 to 10, preferably from 1 to 3, R₄, R₅, R₇, R₈, R₉ and R₁₀ are each chosen independently from alkyl radicals having from 1 to 4 carbon atoms, preferably the methyl radical, R₆ is chosen from alkyl radicals having from 1 to 4 carbon atoms, preferably the methyl radical, and aryl radicals having from 6 to 9 carbon atoms, preferably the phenyl radical, and R₂ has the same meaning as in the above formula (I)
- a group of formula (XVI) 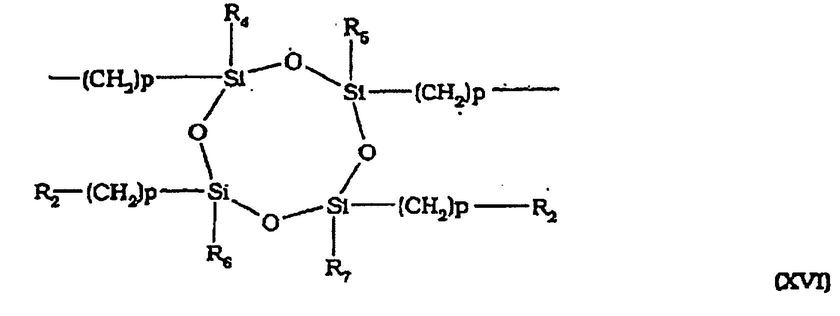 in which R₄, R₅, R₆ and R₇ are each chosen independently from alkyl radicals having from 1 to 4 carbon atoms, preferably the methyl radical, p is an integer from 1 to 20, preferably from 1 to 6, and R₂ has the same meaning as in the above formula (I).

4. Monomers, oligomers or polymers according to one of Claims 1 to 3, **characterized in that** A₁ is the hydrocarbon-comprising backbone of an acid chosen from saturated aliphatic monoacids, saturated or unsaturated aliphatic diacids having from 4 to 40 carbon atoms, aromatic diacids and tricarboxylic acids.

5. Monomers, oligomers or polymers according to one of Claims 1 to 3, **characterized in that** the vinyl monomer of the A₂ block is chosen from acrylic or methacrylic esters and from vinylaromatic monomers copolymerizable with the said esters.

6. Process for the preparation of monomers, oligomers and polymers according to Claim 1, **characterized in that** it comprises the reaction of a monomer or polymer compound of general formula (XVII) 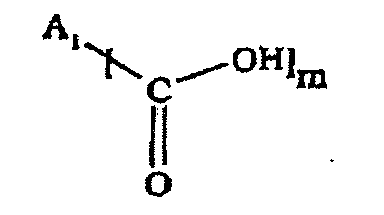 in which A₁ and m are as defined in the formula (I) (for the purpose of obtaining the compounds of formula I), or also of general formula (XVIII) 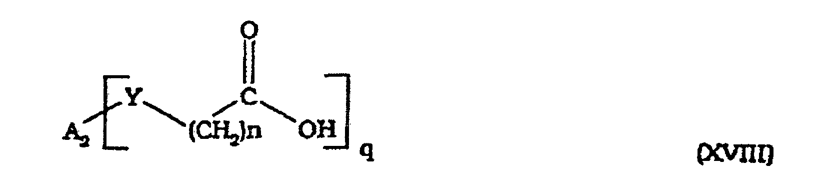 in which A₂, Y, q and n are as defined in the formula (II) (for the purpose of obtaining the compounds of formula II), with a cycloaliphatic diepoxide of general formula (XIX) 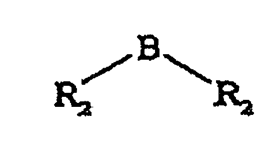 in which B and R₂ are as defined in the formulae (I) and (II), the molar ratio of the diepoxide (XIX) to the monomer or polymer of formula (XVII) or (XVIII) being such that at least one epoxide functional group of the compound (XIX) remains available for another possible subsequent reaction.

7. Preparation process according to Claim 6, **characterized in that** use is made of at least two epoxy equivalents per one carboxylic acid equivalent.

8. Preparation process according to either of Claims 6 and 7, **characterized in that** the reaction is carried out in the presence of at least one solvent.

9. Preparation process according to one of Claims 6 to 8, **characterized in that** the reaction is carried out at a temperature ranging from 100EC to 150EC.

10. Preparation process according to one of Claims 6 to 9, **characterized in that** the reaction is carried out in the presence of a catalytic amount of a compound known to promote the reaction between the epoxide functional group and the carboxylic acid functional group.

11. Preparation process according to Claim 10, **characterized in that** the said compound is chosen from trivalent chromium chloride and trivalent chromium tricarboxylates, quaternary ammonium halides and ferric chloride.

12. Preparation process according to either of Claims 10 and 11, **characterized in that** the said compound is employed in a proportion ranging up to 0.2% by weight with respect to the sum of the monomer or polymer of formula (XVII) or (XVIII) and of the cycloaliphatic diepoxide of formula (XIX).

13. Process for the polymerization under irradiation of a composition comprising at least one monomer, oligomer or polymer of formula (I) or (II) according to Claim 1 in the presence of at least one cationic polymerization photoinitiator and, if appropriate, in the presence of another compound which is cationically polymerizable in the presence of this photoinitiator.

14. Process for the polymerization under irradiation according to Claim 13, **characterized in that** the said cationic polymerization photoinitiator is chosen from aromatic diazonium salts of complex halides, complex salts of aromatic iodonium, complex salts of aromatic sulphonium, onium salts from group VIa and aromatic complex salts of transition metals.

15. Process for the polymerization under irradiation according to either of Claims 13 and 14, **characterized in that** the other cationically polymerizable compound is chosen from monoepoxides which are cycloaliphatic and non-cycloaliphatic and mono- or multifunctional, aliphatic diepoxides, polyglycidyl ethers of polyhydric phenols, aromatic and heterocyclic glycidylated amino resins, resins derived from triglycidyl-p-aminophenol, triazine-based resins, epoxy-hydantoin resins, adducts of alicyclic epoxy alcohols and of (meth)acryloyl isocyanates, epoxidized derivatives of unsaturated natural compounds and of unsaturated synthetic polymers, aliphatic and cyclic vinyl ethers, alkyl vinyl ethers, propenyl ethers and oxetanes.

16. Process for the polymerization under irradiation according to one of Claims 13 to 15, **characterized in that**, when another cationically polymerizable compound is present, it constitutes at most 50% by weight of the composition to be polymerized.

17. Process for the polymerization under irradiation according to one of Claims 13 to 16, **characterized in , that** the cationic photoinitiator is present in a proportion of 0.1% to 10% by weight of the polymerizable organic material.

18. Process for the polymerization under irradiation according to one of Claims 13 to 17, **characterized in that** it is carried out by means of ultraviolet radiation.

19. Process for the polymerization under irradiation according to Claim 18, **characterized in that** the composition additionally comprises a photoinitiator other than the cationic photoinitiator.

20. Process for the polymerization under irradiation according to one of Claims 13 to 19, **characterized in that** the composition additionally comprises at least one additive chosen from photoactivators, wetting or surface-modifying agents, adhesion promoters, inorganic or organic fillers, inorganic pigments, organic colorants, antistatic agents, antifoaming agents and thickening agents.

21. Process for the polymerization under irradiation according to one of Claims 13 to 17, **characterized in that** the irradiation is carried out by means of an electron accelerator.
